# EUROPEAN PATENT APPLICATION

(11) **EP 4 637 292 A1**
(43) Date of publication of application: **22.10.2025**
(21) Application number: 25168240.7
(22) Date of filing: 03.04.2025
(51) Int. Cl.: H10B 41/50, H10B 43/50, H01L 21/768, H01L 23/522, H01L 23/528

(54) **SEMICONDUCTOR DEVICES AND DATA STORAGE SYSTEMS INCLUDING THE SAME**

(30) Priority: 18.04.2024 KR 20240051990
(71) Applicant: Samsung Electronics Co., Ltd., Suwon-si, Gyeonggi-do 16677 (KR)
(72) Inventor: CHUNG, Sunghee, 16677 Suwon-si (KR); KIM, Hyeongjin, 16677 Suwon-si (KR); SHIN, Joongshik, 16677 Suwon-si (KR); HAN, Jeehoon, 16677 Suwon-si (KR)
(74) Representative: Marks & Clerk LLP

(57) **Abstract**

A semiconductor device includes a first semiconductor structure including a substrate, circuit devices on the substrate, and circuit interconnections on the circuit devices, and a second semiconductor structure on the first semiconductor structure and having first and second regions. The second semiconductor structure including a plate layer, gate electrodes stacked and spaced apart from each other on an upper surface of the plate layer in a vertical direction, extending by different lengths on the second region in a first direction intersecting the vertical direction, and including a gate contact region, interlayer insulating layers stacked alternately with the gate electrodes, a channel structure penetrating the gate electrodes and the interlayer insulating layers in the first region and extending in the vertical direction, contact plugs penetrating the gate electrodes in the second region, extending in the vertical direction, and electrically connecting the gate electrodes to a portion of the circuit interconnections, respectively.

## Description

### BACKGROUND

Various example embodiments relate to a semiconductor device and a data storage system including the same.

A semiconductor device able to store high-capacity data in a data storage system is desired. Accordingly, a method for increasing data storage capacity of a semiconductor device has been researched. For example, as a method for increasing integration density of a semiconductor device, a semiconductor device including memory cells and a peripheral circuit region disposed vertically has been suggested.

### SUMMARY

Various example embodiments provide a semiconductor device having improved reliability, and a data storage system including the same.

According to various example embodiments, a semiconductor device includes a first semiconductor structure including a substrate, circuit devices on the substrate, and circuit interconnections on the circuit devices, and a second semiconductor structure on the first semiconductor structure and having first and second regions. The second semiconductor structure including a plate layer, gate electrodes stacked and spaced apart from each other on an upper surface of the plate layer in a vertical direction, extending by different lengths on the second region in a first direction intersecting the vertical direction, and including a gate contact region, interlayer insulating layers stacked alternately with the gate electrodes, a channel structure penetrating the gate electrodes and the interlayer insulating layers in the first region and extending in the vertical direction, contact plugs penetrating the gate electrodes in the second region, extending in the vertical direction, and electrically connecting the gate electrodes to a portion of the circuit interconnections, respectively, and contact insulating layers stacked alternately with the interlayer insulating layers, surrounding the contact plugs, and including first contact insulating layers between the gate contact region and the contact plugs. Each of the contact plugs includes a vertical extension portion extending in the vertical direction, a horizontal extension portion extending from the vertical extension portion in a horizontal direction and overlapping the gate contact region and the first contact insulating layer in the vertical direction, and a conductive liner extending to a region between the horizontal extension portion and the first contact insulating layers and to a region between the horizontal extension portion and the gate contact region.

According to various example embodiments, a semiconductor device may include a stack pattern having a memory cell array region and a staircase region, a stack structure extending from the memory cell array region to the staircase region on the stack pattern. The stack structure may include interlayer insulating layers and gate electrodes stacked alternately in a vertical direction, and the gate electrodes may include gate contact pads arranged in a staircase form on the staircase region. The gate electrodes may include a channel structure penetrating the stack structure in the memory cell array region and extending in the vertical direction. The gate electrodes may include contact plugs penetrating the gate electrodes and the interlayer insulating layers in the staircase region. The gate electrodes may include contact insulating layers stacked alternately with the interlayer insulating layers and surrounding the contact plugs. The contact insulating layers may include first contact insulating layers between the gate contact pads and the contact plugs. The contact insulating layers may include second contact insulating layers stacked alternately with the interlayer insulating layers in a lower portion of the gate contact pads. The second contact insulating layers may surround the contact plugs. Each of the contact plugs may include a vertical extension portion extending in the vertical direction, a horizontal extension portion extending from the vertical extension portion in a horizontal direction. The horizontal extension portion may be in contact with each of the first contact insulating layers and the gate contact pads. A height of each of the first contact insulating layers may be smaller than a height of each of the second contact insulating layers.

According to various example embodiments, a data storage system includes a semiconductor storage device including a first semiconductor structure including circuit devices and circuit interconnections electrically connected to the circuit devices, a second semiconductor structure on one surface of the first semiconductor structure and including a first region and a second region, and an input/output pad electrically connected to the circuit devices, and a controller electrically connected to the semiconductor storage device through the input/output pad and controlling the semiconductor storage device. The second semiconductor structure may include a plate layer, and gate electrodes stacked and spaced apart from each other in a vertical direction on an upper surface of the plate layer. The gate electrodes may extend by different lengths on the second region in a first direction intersecting the vertical direction, and respectively including a gate contact region, interlayer insulating layers stacked alternately with the gate electrodes, a channel structure penetrating the gate electrodes and the interlayer insulating layers in the first region and extending in the vertical direction. Contact plugs may penetrate the gate contact region of each of the gate electrodes in the second region, extending in the vertical direction, and electrically connecting the gate electrodes to a portion of the circuit interconnections, respectively. First contact insulating layers may be stacked alternately with the interlayer insulating layers between the gate contact region and the contact plugs. The first contact insulating layers may surround the contact plugs, second contact insulating layers stacked alternately with the interlayer insulating layers in a lower portion of the gate contact region. The second contact insulating layers may surround the contact plugs. Each of the contact plugs may include a vertical extension portion extending in the vertical direction, a horizontal extension portion extending from the vertical extension portion in a horizontal direction, the horizontal extension portion overlapping each of the first contact insulating layers and the gate contact region. A conductive liner may extend to a region between the horizontal extension portion and the first contact insulating layers. The conductive liner may further extend to a region between the horizontal extension portion and the gate contact region.

At least some of the above and other features of the invention are set out in the claims.

### BRIEF DESCRIPTION OF DRAWINGS

The above and other aspects, features, and advantages of various example embodiments will be more clearly understood from the following detailed description, taken in combination with the accompanying drawings, in which:
FIG. 1A is a plan diagram illustrating a semiconductor device according to various example embodiments;
FIG. 1B is a cross-sectional diagram illustrating various example embodiments of a semiconductor device, taken along line I-I' in FIG. 1A;
FIG. 1C is a cross-sectional diagram illustrating various example embodiments of a semiconductor device, taken along line II-II' in FIG. 1A;
FIG. 2 is an enlarged diagram illustrating region A of the semiconductor device illustrated in FIG. 1B according to various example embodiments;
FIG. 3A is an enlarged diagram illustrating various example embodiments of region B of the semiconductor device illustrated in FIG. 2;
FIG. 3B is an enlarged diagram illustrating various example embodiments of region C of the semiconductor device in FIG. 3A;
FIGS. 4A to 4C are enlarged diagrams illustrating various example embodiments of region B of the semiconductor device illustrated in FIG. 2;
FIGS. 5A to 5F are cross-sectional diagrams illustrating various example embodiments of a method of manufacturing a semiconductor device in FIG. 1B;
FIGS. 6A to 6J are cross-sectional diagrams illustrating various example embodiments of a method of manufacturing a semiconductor device in FIG. 3A;
FIGS. 7A to 7C are cross-sectional diagrams illustrating various example embodiments of a method of manufacturing a semiconductor device in FIG. 4B;
FIGS. 8A to 8G are cross-sectional diagrams illustrating various example embodiments of a method of manufacturing a semiconductor device in FIG. 4C;
FIGS. 9 and 10 are cross-sectional diagrams illustrating a semiconductor device according to various example embodiments;
FIG. 11 is a diagram illustrating a data storage system including a semiconductor device according to various example embodiments;
FIG. 12 is a perspective diagram illustrating a data storage system including a semiconductor device according to various example embodiments; and
FIG. 13 is a cross-sectional diagram illustrating a semiconductor package according to various example embodiments.

### DETAILED DESCRIPTION

Hereinafter, various example embodiments will be described as follows with reference to the accompanying drawings.

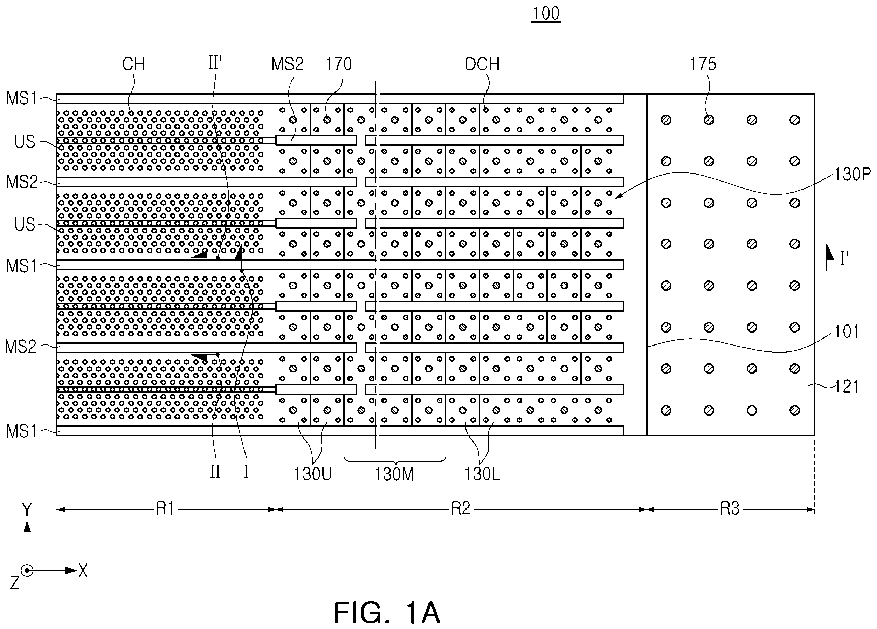

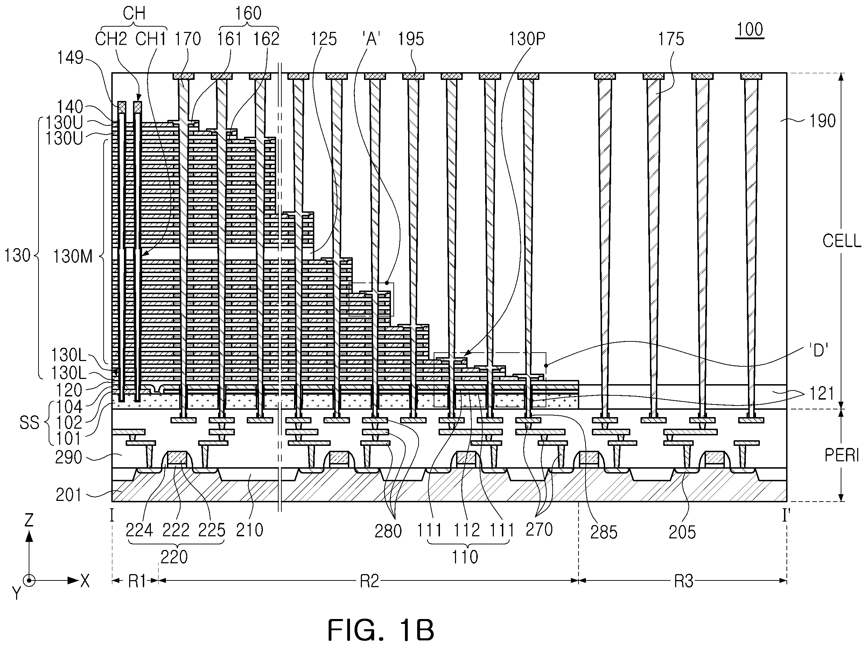

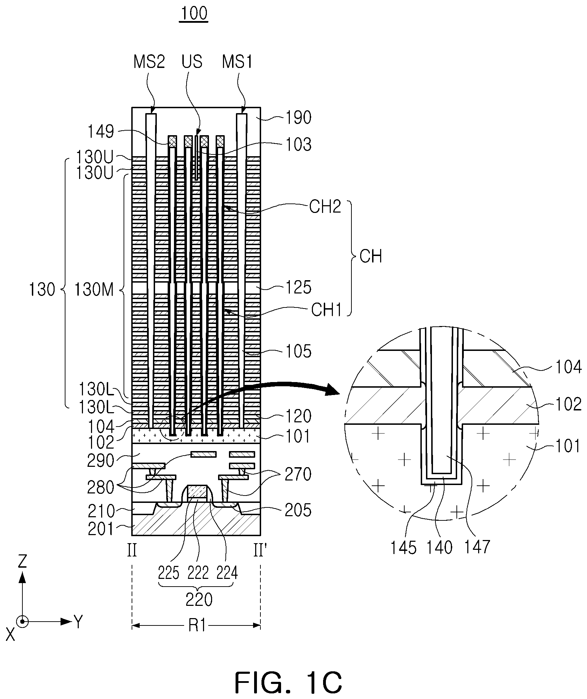

FIG. 1A is a plan diagram illustrating a semiconductor device according to various example embodiments. FIG. 1B is a cross-sectional diagram illustrating various example embodiments of a semiconductor device, taken along line I-I' in FIG. 1A. FIG. 1C is a cross-sectional diagram illustrating various example embodiments of a semiconductor device, taken along line II-II' in FIG. 1A.

Referring to FIGS. 1A to 1C, a semiconductor device 100 may include a peripheral circuit region PERI, which is a first semiconductor structure including a first substrate 201, and a memory cell region CELL, which is a second semiconductor structure including a second substrate 101. The memory cell region CELL may be disposed in an upper portion of the peripheral circuit region PERI. In another example, the memory cell region CELL may be disposed in a lower portion of the peripheral circuit region PERI.

The peripheral circuit region PERI may include a first substrate 201, source/drain regions 205 in the first substrate 201, source isolation layers 210, circuit devices 220 disposed on the first substrate 201, circuit contact plugs 270, circuit interconnection lines 280, and a peripheral region insulating layer 290.

The first substrate 201 may have an upper surface extending in the first direction (X-direction) and the second direction (Y-direction). In the first substrate 201, an active region may be defined by the source isolation layers 210. A source/drain region 205 including impurities may be disposed in a portion of the active region. The first substrate 201 may include a semiconductor material, such as a group IV semiconductor, a group III-V compound semiconductor, or a group II-VI compound semiconductor. The first substrate 201 may be provided as a bulk wafer or an epitaxial layer.

The circuit devices 220 may include planar transistors. Each of the circuit devices 220 may include a circuit gate dielectric layer 222, a spacer layer 224, and a circuit gate electrode 225. Source/drain regions 205 may be disposed in the first substrate 201 on both sides of the circuit gate electrode 225.

The peripheral region insulating layer 290 may be disposed on the circuit devices 220 on the first substrate 201. The circuit contact plugs 270 may penetrate the peripheral region insulating layer 290 and may be connected to the source/drain regions 205. In regions not illustrated, the circuit contact plugs 270 may also be connected to the circuit gate electrode 225. The circuit interconnection lines 280 may be connected to the circuit contact plugs 270 and may be disposed of in a plurality of layers.

The memory cell region CELL may include a first region R1, a second region R2, and a third region R3, a source structure SS including the second substrate 101, gate electrodes 130 stacked on the source structure SS, interlayer insulating layers 120 alternately stacked with the gate electrodes 130, channel structures CH disposed to penetrate a stack structure of the gate electrodes 130 in the first region R1, first and second isolation regions MS1 and MS2 penetrating and extending the stack structure of the gate electrodes 130, contact plugs 170 extending by penetrating the gate electrodes 130 in the second region R2, and through-plugs 175 disposed in the third region R3 on an external side of the second substrate 101. The memory cell region CELL may further include contact insulating layers 160 surrounding the contact plugs 170.

The memory cell region CELL may include a first horizontal conductive layer 102 on the first region R1, a horizontal insulating layer 110 disposed side by side with the first horizontal conductive layer 102 on the second region R2 of the second substrate 101, a second horizontal conductive layer 104 on the first horizontal conductive layer 102 and the horizontal insulating layer 110, a substrate insulating layer 121 penetrating the second substrate 101, upper isolation regions US penetrating a portion of the stack structure of gate electrodes 130, dummy channel structures DCH disposed to penetrate a stack structure of the gate electrodes 130 in the second region R2, a cell region insulating layer 190, and cell interconnection lines 195.

The source structure SS may include a second substrate 101, a first horizontal conductive layer 102, and a second horizontal conductive layer 104 stacked in order. The second substrate 101 may have a shape of a plate and may function as at least a portion of the common source line of the semiconductor device 100. The second substrate 101 may include a conductive material, for example, a semiconductor material. The second substrate 101 may further include impurities. The second substrate 101 may be provided as a polycrystalline semiconductor layer such as a polycrystalline silicon layer or an epitaxial layer. In various example embodiments, the source structure SS may be referred to as a plate structure, and the second substrate 101 may be referred to as a plate layer.

The first and second horizontal conductive layers 102 and 104 may be stacked in order on an upper surface of the first region R1 of the second substrate 101. In some examples, the first horizontal conductive layer 102 may not extend to an upper surface of the second region R2, and the second horizontal conductive layer 104 may extend into the second region R2.

The first horizontal conductive layer 102 may function as a portion of the common source line of the semiconductor device 100, for example, functioning as a common source line together with the second substrate 101. The first horizontal conductive layer 102 may be directly connected to the channel layer 140 in the channel structure CH.

The second horizontal conductive layer 104 may be in contact with the second substrate 101 in partial regions in which the first horizontal conductive layer 102 and the horizontal insulating layer 110 are not disposed. The second horizontal conductive layer 104 may cover an end of the first horizontal conductive layer 102 or the horizontal insulating layer 110 in partial upper regions and may be bent to extend to the second substrate 101.

The first and second horizontal conductive layers 102 and 104 may include a semiconductor material. For example, the first and second horizontal conductive layers 102 and 104 may both include polycrystalline silicon. In this case, at least the first horizontal conductive layer 102 may be a doped layer, and the second horizontal conductive layer 104 may be a doped layer or a layer including impurities diffused from the first horizontal conductive layer 102. However, in various example embodiments, the second horizontal conductive layer 104 may be replaced with an insulating layer.

The horizontal insulating layer 110 may be disposed on the second substrate 101 on the same level as the first horizontal conductive layer 102. The horizontal insulating layer 110 may include first and second horizontal insulating layers 111 and 112. The horizontal insulating layer 110 may be layers remaining after a portion thereof is replaced with the first horizontal conductive layer 102 in a process of manufacturing the semiconductor device 100. The horizontal insulating layer 110 may include silicon oxide, silicon nitride, silicon carbide, or silicon oxynitride. However, example embodiments are not limited thereto. In various example embodiments, the first horizontal insulating layer 111 and the second horizontal insulating layer 112 may include different insulating materials.

The substrate insulating layers 121 may extend from the second region R2 in the third direction (Z-direction) and may penetrate the second substrate 101, the horizontal insulating layer 110, and the second horizontal conductive layer 104. The substrate insulating layer 121 may be disposed to surround each of the contact plugs 170. Accordingly, the contact plugs 170 connected to different gate electrodes 130 may be electrically isolated from each other. The substrate insulating layer 121 may also be disposed in the third region R3 to surround each of the through-plugs 175.

The substrate insulating layers 121 may include an insulating material, for example, silicon oxide, silicon nitride, silicon carbide, or silicon oxynitride. However, example embodiments are not limited thereto.

The gate electrodes 130 may be vertically stacked and spaced apart from each other on the second substrate 101 and may form a stack structure. The gate electrodes 130 may include lower gate electrodes 130L included in a gate of the ground select transistor, a plurality of memory cells included in memory gate electrodes 130M, and upper gate electrodes 130U included in gates of string select transistors. The number of memory gate electrodes 130M included in the memory cells may be determined depending on the capacity of the semiconductor device 100. In various example embodiments, the number of the upper gate electrodes 130U and the number of the lower gate electrodes 130L may be 1 to 4 or more, respectively, and may have a structure the same as or different from that of the memory gate electrodes 130M. In various example embodiments, the gate electrodes 130 may further include a gate electrode 130 disposed in a lower portion of the upper gate electrodes 130U and/or the lower gate electrodes 130L and included in an erase transistor used in an erase operation using a gate induced leakage current (GIDL) phenomenon. Also, a portion of the gate electrodes 130, for example, the memory gate electrodes 130M adjacent to the upper gate electrodes 130U or the lower gate electrodes 130L, may be dummy gate electrodes.

The gate electrodes 130 may be vertically stacked and spaced apart from each other on the first region R1, may extend to different lengths from the first region R1 to the second region R2 and may form a step structure having a staircase form. The gate electrodes 130 may form a step structure between the gate electrodes 130 in the first direction (X-direction), and may be disposed to have a step structure as viewed in the second direction (Y-direction). Due to the step structure, the gate electrodes 130 of the lower portion may extend longer than the gate electrodes 130 of the upper portion, may be exposed upwardly from the interlayer insulating layers 120, and may have regions in contact with the contact plugs 170, respectively, and the regions may be referred to as gate contact regions 130P. In each of the gate electrodes 130, the gate contact region 130P may include the end in the first direction (X-direction). The gate contact region 130P may correspond to a portion of the gate electrodes 130 included in the stack structure in the second region R2 of the second substrate 101. The gate electrodes 130 may be connected to the contact plugs 170 in the gate contact region 130P.

The gate electrodes 130 may be isolated from each other in the second direction (Y-direction) by the first isolation regions MS1 extending in the first direction (X-direction). The gate electrodes 130 between a pair of the first isolation regions MS1 may form a memory block, but an example embodiment of the memory block is not limited thereto. The gate electrodes 130 may include a metal material, such as tungsten (W). In various example embodiments, the gate electrodes 130 may include polycrystalline silicon or metal silicide material.

The interlayer insulating layers 120 may be disposed between the gate electrodes 130. Similarly to the gate electrodes 130, the interlayer insulating layers 120 may be spaced apart from each other in a direction perpendicular to an upper surface of the second substrate 101 and may extend in the first direction (X-direction). The interlayer insulating layers 120 may include an insulating material such as silicon oxide or silicon nitride.

The first and second isolation regions MS1 and MS2 may penetrate the gate electrodes 130 and may extend in the first direction (X-direction). The first and second isolation regions MS1 and MS2 may be disposed parallel to each other. The first and second isolation regions MS1 and MS2 may penetrate the entirety of the gate electrodes 130 stacked on the second substrate 101 and may be connected to the second substrate 101. The first isolation regions MS1 may extend as an integrated region in the first direction (X-direction), and the second isolation regions MS2 may extend intermittently between a pair of the first isolation regions MS1 or may be disposed only in partial regions. However, in various example embodiments, the arrangement order of the first and second isolation regions MS1 and MS2 and the number of the first and second isolation regions MS1 and MS2 are not limited to the examples illustrated in FIG. 1A. As illustrated in FIG. 1C, the isolation insulating layer 105 may be disposed in the first and second isolation regions MS1 and MS2.

As illustrated in FIGS. 1A and 1C, the upper isolation regions US may extend in the first direction (X-direction) between the first isolation regions MS1 and the second isolation regions MS2 in the first region R1. For example, the upper isolation regions US may isolate three gate electrodes 130, including upper gate electrodes 130U, from each other in the second direction (Y-direction). However, the number of the gate electrodes 130 isolated by the upper isolation regions US may be varied in various example embodiments. The upper gate electrodes 130U isolated by the upper isolation regions US may form different string select lines. The upper isolation insulating layer 103 may be disposed in the upper isolation regions US. The upper isolation insulating layer 103 may include an insulating material, for example, silicon oxide, silicon nitride, or silicon oxynitride.

As illustrated in FIG. 1A, the channel structures CH may form a memory cell string and may be spaced apart from each other while forming rows and columns on the first region R1. The channel structures CH may be disposed to form a grid pattern or may be disposed in a zigzag pattern in one direction, or in any suitable formation. The channel structures CH may have a pillar shape and may have an inclined side surface having a width decreasing toward the second substrate 101 depending on an aspect ratio.

The channel structures CH may include first and second channel portions CH1 and CH2 stacked vertically, as illustrated in FIG. 1B. Each channel structure CH may have a form in which the first channel portion CH1 penetrating the lower portion stack structure of the gate electrodes 130, and the second channel portion CH2 penetrating the upper portion stack structure of the gate electrodes 130, are connected to each other, and may include a bent portion due to a difference in width in the connection region. However, in various example embodiments, the number of the channel structures stacked in the third direction (Z-direction) may be varied.

As illustrated in the enlarged diagram in FIG. 1C, the channel layer 140 may be disposed in the channel structures CH. In the channel structures CH, the channel layer 140 may be formed in an annular shape surrounding a channel filling the insulating layer 147. The channel layer 140 may be connected to the first horizontal conductive layer 102 in a lower portion. The channel layer 140 may include a semiconductor material such as polycrystalline silicon or single crystalline silicon.

The gate dielectric layer 145 may be disposed between the gate electrodes 130 and the channel layer 140. Although not specifically illustrated, the gate dielectric layer 145 may include a tunneling layer, a charge storage layer, and a blocking layer stacked in order from the channel layer 140. The tunneling layer may tunnel charges into the charge storage layer and may include, for example, silicon oxide (SiO₂), silicon nitride (Si₃N₄), silicon oxynitride (SiON), or combinations thereof. However, example embodiments are not limited thereto. The charge storage layer may be a charge trap layer or a floating gate conductive layer. The blocking layer may include silicon oxide (SiO₂), silicon nitride (SiO₂), silicon oxynitride (SiON), a high-κ material, or a combination thereof. However, example embodiments are not limited thereto. In various example embodiments, at least a portion of the gate dielectric layer 145 may extend in the horizontal direction along the gate electrodes 130. In some examples, a channel pad 149 may be disposed on an upper end only of the second channel portion CH2 of the upper portion, but in other examples the channel pad 149 may be formed differently than as shown in Fig. 1C. The channel pad 149 may include, for example, doped polycrystalline silicon.

The channel layer 140, the gate dielectric layer 145, and the channel filling insulating layer 147 may be connected to each other between the first channel portion CH1 and the second channel portion CH2. An upper interlayer insulating layer 125 having a relatively great thickness may be disposed between the first channel portion CH1 and the second channel portion CH2, that is, between the lower stack structure and the upper stack structure. However, shapes of the interlayer insulating layers 120 and the upper interlayer insulating layer 125 may be varied in various example embodiments.

The dummy channel structures DCH may be spaced apart from each other in rows and columns in the second region R2. The dummy channel structures DCH may have a size larger than a size of the channel structures CH on the plan diagram, but example embodiments thereof are not limited thereto. The dummy channel structures DCH may be further disposed in a portion of the first region R1 adjacent to the second region R2. The dummy channel structures DCH may not be electrically connected to the interconnection structures of the upper portion, and may not form a memory cell string in the semiconductor device 100, differently from the channel structures CH.

The dummy channel structures DCH may have a structure the same as or different from that of the channel structures CH. When the dummy channel structures DCH are formed together with the channel structures CH, the dummy channel structures DCH may have the same structure as that of the channel structures CH. When the dummy channel structures DCH are formed using a portion of the process of forming the contact plugs 170, the dummy channel structures DCH may have a structure different from that of the channel structures CH. In this case, for example, the dummy channel structures DCH may have a structure filled with an insulating material such as an oxide.

The contact plugs 170 may penetrate the gate electrodes 130 and the interlayer insulating layers 120 in an uppermost portion in the second region R2, and may be connected to the gate contact regions 130P of the gate electrodes 130. The contact plugs 170 may be disposed to penetrate at least a portion of the cell region insulating layer 190, to extend toward the gate contact region 130P, and to be connected to each of the gate contact regions 130P of the gate electrodes 130.

The contact plugs 170 may penetrate the second substrate 101, the second horizontal conductive layer 104, and the horizontal insulating layer 110 in a lower portion of the gate electrodes 130 and may be connected to the circuit interconnection lines 280 in the peripheral circuit region PERI. The contact plugs 170 may be spaced apart from the second substrate 101, the second horizontal conductive layer 104, and the horizontal insulating layer 110 by the substrate insulating layer 121.

The contact plugs 170 may be surrounded by the substrate insulating layer 121 and may be electrically isolated from the second substrate 101. In various example embodiments, a region including a lower end of the contact plugs 170 may be surrounded by the pad layers 285 on the circuit interconnection lines 280. However, in various example embodiments the contact plugs 170 may be formed to not extend in the pad layers 285 and may be in contact with the pad layers 285. The pad layers 285 may protect the circuit interconnection lines 280 during the process of manufacturing the semiconductor device 100, and may include a conductive material, for example, polycrystalline silicon. However, example embodiments are not limited thereto.

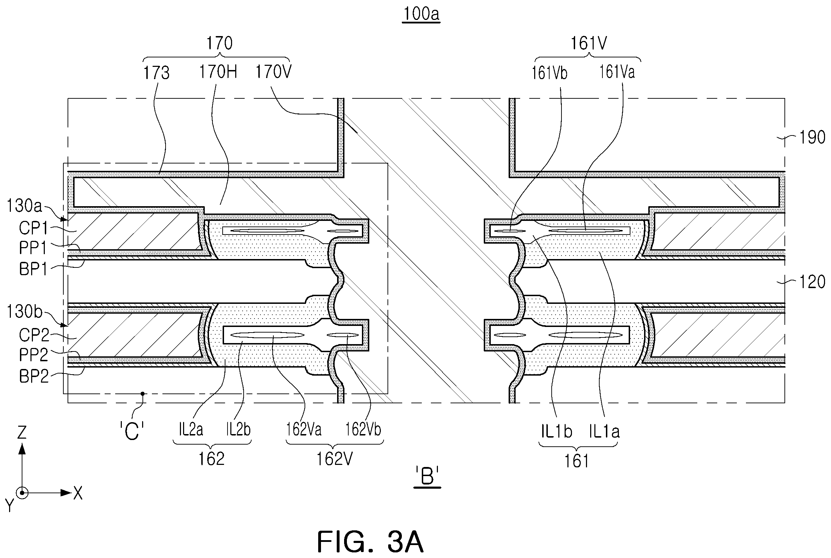

For example, the contact plugs 170 may include at least one of tungsten (W), copper (Cu), aluminum (Al), and alloys thereof. In various example embodiments, the contact plugs 170 may further include a barrier layer (e.g., the conductive liner 173 in FIG. 3A) on sidewalls and bottom surfaces of the contact holes in which the contact plugs 170 are disposed. For example, the barrier layer may include at least one of titanium (Ti), titanium nitride (TiN), tantalum (Ta), and tantalum nitride (TaN). However, example embodiments are not limited thereto.

The contact insulating layers 160 may be alternately disposed with the interlayer insulating layers 120 and may surround the contact plugs 170. The contact insulating layers 160 may include a first contact insulating layer 161 disposed between the gate contact regions 130P and the contact plugs 170 and surrounding a side surface of the contact plugs 170, and a second contact insulating layer 162 disposed in a lower portion of the gate contact regions 130P and surrounding side surfaces of the contact plugs 170. An internal side surface of the contact insulating layers 160 may surround the contact plugs 170, and the external side surface of the contact insulating layers 160 may be surrounded by the gate electrodes 130. The contact plugs 170 may be physically and electrically connected to the gate contact region 130P by the contact insulating layers 160, and may be electrically isolated from the gate electrodes 130 in a lower portion of the gate contact region 130P.

The through-plugs 175 may be disposed in the third region R3 of the memory cell region CELL, which is the external side region of the second substrate 101, and may penetrate the cell region insulating layer 190 and may extend to the peripheral circuit region PERI. The through-plugs 175 may be disposed to connect the cell interconnection lines 195 of the memory cell region CELL to the circuit interconnection lines 280 of peripheral circuit region PERI. The through-plugs 175 may include a conductive material, for example, a metal material such as tungsten (W), copper (Cu), and aluminum (Al). However, example embodiments are not limited thereto. The through-plugs 175 may be formed in the same process of forming the contact plugs 170, may include the same material as that of the contact plugs 170, and may have the same internal structure as that of the contact plugs 170.

The cell region insulating layer 190 may be disposed to cover the second substrate 101, the gate electrodes 130 on the second substrate 101, and the peripheral region insulating layer 290. The cell region insulating layer 190 may be formed of an insulating material and may include a plurality of insulating layers.

The cell interconnection lines 195 may be included in an upper interconnection structure electrically connected to memory cells in the memory cell region CELL. The cell interconnection lines 195 may be connected to the contact plugs 170 and the through-plugs 175, and may be electrically connected to the gate electrodes 130 and the channel structures CH via the gate electrodes 130. In various example embodiments, the number of contact plugs and the interconnection lines included in the upper interconnection structure may be varied. The cell interconnection lines 195 may include a metal, for example, tungsten (W), copper (Cu), aluminum (Al), or the like. However, example embodiments are not limited thereto.

In various example embodiments, the first direction (X-direction) and the second direction (Y-direction) may be perpendicular to each other. The first direction (X-direction) and the second direction (Y-direction) may be perpendicular to the third direction (Z-direction). The horizontal direction may refer to the first direction (X-direction) and the second direction (Y-direction).

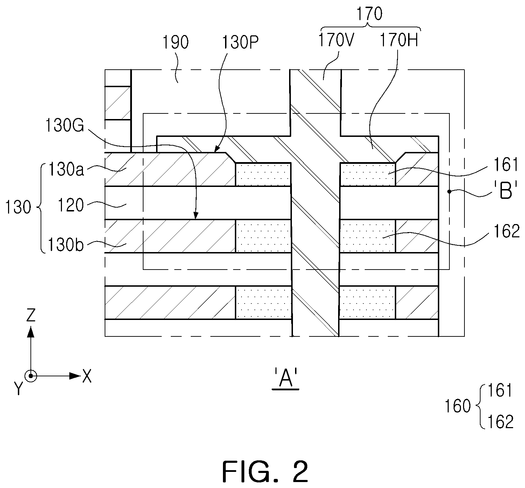

FIG. 2 is an enlarged diagram illustrating region A of the semiconductor device illustrated in FIG. 1B according to various example embodiments.

Referring to FIG. 2, contact plugs 170 may be connected to a gate electrode among gate electrodes 130 through a gate contact region 130P.

Each of the gate electrodes 130 may include a gate contact region 130P and a gate stack region 130G, which is the region other than the gate contact region 130P. The gate contact region 130P may be a region of the gate electrode layer not covered by other gate electrodes by a step structure. The gate stack region 130G may be a region of the gate electrode layer covered by other gate electrodes. The gate contact region 130P may overlap a horizontal extension portion 170H of the contact plug 170 in the third direction (Z-direction) and may be in contact with a lower side surface of the horizontal extension portion 170H.

The gate electrodes 130 may include a first gate electrode portion 130a corresponding to the gate contact region 130P and a second gate electrode portion 130b corresponding to the gate stack region 130G. In various example embodiments, the first gate electrode portion 130a may be referred to as a gate contact pad, and the second gate electrode portion 130b may be referred to as a gate stack structure.

The contact insulating layers 160 may include a first contact insulating layer 161 disposed between the gate contact region 130P and a vertical extension portion 170V of the contact plug 170, and a second contact insulating layer 162 disposed between the gate stack region 130G and the vertical extension portion 170V. The contact plug 170 may be electrically isolated from the second gate electrode portion 130b in a lower portion of the gate contact region 130P by the second contact insulating layer 162.

Lengths of the first and second contact insulating layers 161 and 162 in the horizontal direction may be the same. In various example embodiments, the length of the first contact insulating layer 161 in the third direction (Z-direction) may be smaller than the length of the second contact insulating layer 162 in the third direction (Z-direction). In various example embodiments, an upper surface of the first contact insulating layer 161 may be disposed on a level lower than a level of an upper surface of the gate contact region 130P (or the first gate electrode portion 130a). However, example embodiments thereof are not limited thereto, and the upper surface of the first contact insulating layer 161 may be disposed on the same level as the upper surface of the gate contact region 130P. In various example embodiments, the upper surface of the second contact insulating layer 162 may be disposed on the same level as the upper surface of the gate stack region 130G (or the second gate electrode portion 130b).

The contact plugs 170 may have a shape enlarged in the horizontal direction toward the gate contact region 130P and the first contact insulating layer 161. In various example embodiments, the contact plugs 170 may include a vertical extension portion 170V penetrating gate electrodes 130 and interlayer insulating layers 120 and extending in the third direction (Z-direction), and a horizontal extension portion 170H extending from the vertical extension portion 170V in the horizontal direction and in contact with an upper surface of the gate contact region 130P and an upper surface of the first contact insulating layer 161. In various example embodiments, the horizontal extension portion 170H may be disposed along a circumference of the vertical extension portion 170V, a side surface and an upper surface of the horizontal extension portion 170H may be covered by the cell region insulating layer 190, and a lower surface of the horizontal extension portion 170H may be covered by the first gate electrode portion 130a and the first contact insulating layer 161.

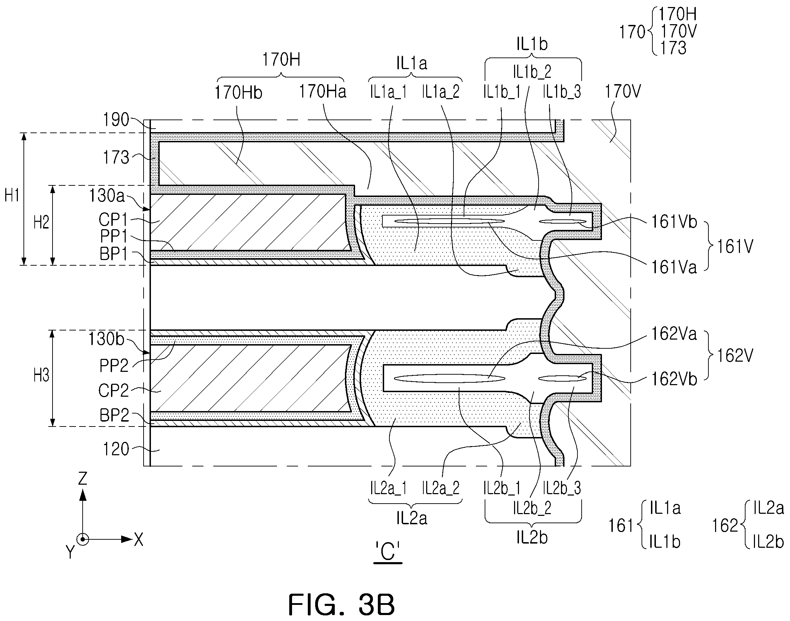

FIG. 3A is an enlarged diagram illustrating various example embodiments of region B of the semiconductor device illustrated in FIG. 2. FIG. 3B is an enlarged diagram illustrating various example embodiments of region C of the semiconductor device in FIG. 3A.

Referring to FIGS. 3A and 3B, a semiconductor device 100a may include a contact plug 170, first and second gate electrode portions 130a and 130b, and first and second contact insulating layers 161 and 162.

The contact plug 170 may include a vertical extension portion 170V penetrating the gate electrode 130 and the interlayer insulating layers 120, a horizontal extension portion (e.g., the horizontal extension portion 170H in FIG. 2) extending from the vertical extension portion 170V to the first gate electrode portion 130a and the first contact insulating layer 161, and a conductive liner 173 covering a side surface of the vertical extension portion 170V and a surface of the horizontal extension portion 170H. In various example embodiments, the vertical extension portion 170V may penetrate the first and second gate electrode portions 130a and 130b and interlayer insulating layers 120 and may extend in the third direction (Z-direction). The horizontal extension portion 170H may extend in the horizontal direction from the vertical extension portion 170V, and may overlap and/or may be in contact with the first gate electrode portion 130a and the first contact insulating layer 161 in the third direction (Z-direction). The horizontal extension portion 170H may include a first horizontal extension portion 170Ha in contact with the first contact insulating layer 161 and a second horizontal extension portion 170Hb in contact with the first gate electrode portion 130a. In various example embodiments, a vertical height of the first horizontal extension portion 170Ha may be greater than a vertical height of the second horizontal extension portion 170Hb.

The conductive liner 173 may function as a metal barrier layer of the contact plug 170. The conductive liner 173 may be disposed according to a surface profile of the vertical extension portion 170V and the horizontal extension portion 170H. The conductive liner 173 may cover a side surface of the vertical extension portion 170V, may extend from a side surface of the vertical extension portion 170V and may cover a surface of the horizontal extension portion 170H. That is, the conductive liner 173 may extend to a region between the horizontal extension portion 170H and the cell region insulating layer 190, to a region between the second horizontal extension portion 170Hb and the first gate electrode portion 130a, and to a region between the first horizontal extension portion 170Ha and the first contact insulating layer 161. The conductive liner 173 may include at least one of titanium (Ti), titanium nitride (TiN), tantalum (Ta), and tantalum nitride (TaN). However, example embodiments are not limited thereto.

The first gate electrode portion 130a may include a first conductive layer CP1 and a first barrier layer PP1 extending from at least a portion of an external side surface of the first conductive layer CP1 and disposed on a lower surface of the first conductive layer CP1. The first barrier layer PP1 may be a barrier layer in which the conductive liner 173 may extend to a region between the first conductive layer CP1 and the first contact insulating layer 161 and may cover a lower surface of the first conductive layer CP1. The first conductive layer CP1 may be covered by the conductive liner 173 and the first barrier layer PP1. In various example embodiments, the first gate electrode portion 130a may further include a first blocking layer BP1 covering a portion of the first conductive layer CP1. The first blocking layer BP1 may extend a region from between the first barrier layer PP1 and the first contact insulating layer 161 and may cover a lower surface of the first barrier layer PP1.

The second gate electrode portion 130b may include a second conductive layer CP2 and a second barrier layer PP2 disposed according to a surface profile of the second conductive layer CP2. The second gate electrode portion 130b may further include a second blocking layer BP2 covering the second barrier layer PP2.

A height H1 from a lower surface of the first gate electrode portion 130a to an upper surface of the horizontal extension portion 170H may be greater than a height H3 in the third direction (Z-direction) of the second gate electrode portion 130b.

A height H2 in the third direction (Z-direction) of the first gate electrode portion 130a may be lower than the height H3 in the third direction (Z-direction) of the second gate electrode portion 130b. For example, the height H2 of the first gate electrode portion 130a may be from about 17 nm to about 21 nm, and the height H3 of the second gate electrode portion 130b may be from about 26 nm to about 27 nm.

The first and second conductive layers CP1 and CP2 may include a metal material. For example, the first and second conductive layers CP1 and CP2 may include tungsten (W). In various example embodiments, the first and second conductive layers CP1 and CP2 may include the same material as a material of the vertical extension portion 170V and the horizontal extension portion 170H of the contact plug 170. However, example embodiments thereof are not limited thereto, and the first and second conductive layers CP1 and CP2 may include a metal material different from a material of the vertical extension portion 170V and the horizontal extension portion 170H of the contact plug 170.

The first and second barrier layers PP1 and PP2 may include the same material as a material of the conductive liner 173. However, example embodiments thereof are not limited thereto, and the first and second barrier layers PP1 and PP2 may include a conductive material different from a material of the conductive liner 173. For example, the first and second barrier layers PP1 and PP2 may include at least one of titanium (Ti), titanium nitride (TiN), tantalum (Ta), and tantalum nitride (TaN). However, example embodiments are not limited thereto.

The first and second blocking layers BP1 and BP2 may include metal oxide. For example, the first and second blocking layers BP1 and BP2 may include aluminum oxide (AlO). However, example embodiments are not limited thereto.

The first contact insulating layer 161 may be disposed between the first gate electrode portion 130a and the vertical extension portion 170V. An external side surface of the first contact insulating layer 161 adjacent to the first gate electrode portion 130a may be in contact with the first blocking layer BP1, and an upper surface of the first contact insulating layer 161 may be in contact with the conductive liner 173. In various example embodiments, the upper surface of the first contact insulating layer 161 may be disposed on a level lower than a level of the upper surface of the first gate electrode portion 130a.

The second contact insulating layer 162 may be disposed between the second gate electrode portion 130b and the vertical extension portion 170V. The external side surface of the second contact insulating layer 162 may be in contact with the second blocking layer BP2, and the upper surface and the lower surface of the second contact insulating layer 162 may be in contact with the interlayer insulating layer 120. The upper surface and the lower surface of the second contact insulating layer 162 may be disposed on the same level as a level of the upper surface and the lower surface of the second gate electrode portion 130b.

The first contact insulating layer 161 and the second contact insulating layer 162 may include the first insulating patterns IL1a and IL2a and the second insulating patterns IL1b and IL2b, a portion of which is surrounded by the first insulating pattern IL1a and IL2a respectively. The first contact insulating layer 161 may include a 1-1 insulating pattern IL1a and a 1-2 insulating pattern IL1b having a portion surrounded by the 1-1 insulating pattern IL1a. The second contact insulating layer 162 may include a 2-1 insulating pattern IL2a and a 2-2 insulating pattern IL2b having a portion surrounded by the 2-1 insulating pattern IL2a.

The first insulating patterns IL1a and IL2a may include respective first flat portions IL1a_1, IL2a_1 flat in the horizontal direction, and respective first protrusions IL1a_2 and IL2a_2 extending from the first flat portions IL1a_1, IL2a_1 and protruding toward the interlayer insulating layer 120 between the first flat portions IL1a_1, IL2a_1 and the vertical extension portion 170V.

The second insulating patterns IL1b and IL2b may include respective second flat portions IL1b_1, IL2b_1 surrounded by the first flat portions IL1a_1, IL2a_1 of the first insulating patterns IL1a and IL2a, respective second protrusions IL1b_2, IL2b_2 surrounded by the first protrusions IL1a_2 and IL2a_2 of the first insulating patterns IL1a and IL2a, and having a thickness gradually increasing toward the vertical extension portion 170V to correspond to the first protrusions IL1a_2 and IL2a _2, and respective third protrusions IL1b_3 and IL2b_3 protruding toward the vertical extension portion 170V from ends of the second protrusions IL1b_2, IL2b_2.

The first flat portions IL1a_1 and IL2a_1 may each have a first height in the third direction (Z-direction), and the respective first protrusions IL1a_2 and IL2a_2 may each have a second height higher than the respective first height. The first contact insulating layer 161 and the second contact insulating layer 162 may include a bent portion due to a difference in heights between the first flat portions IL1a_1 and IL2a_1 and the first protrusions IL1a_2 and IL2a_2. In various example embodiments, a bent portion may be disposed and/or formed on a lower surface of the first contact insulating layer 161 due to a difference in heights in the third direction (Z-direction) between the first flat portion IL1a_1 and the first protrusion IL1a_2. A bent portion may be disposed and/or formed on an upper surface and a lower surface of the second contact insulating layer 162 due to a difference in heights in the third direction (Z-direction) between the first flat portion IL2a_1 and first protrusion IL2a_2.

In various example embodiments, an upper surface of the first flat portion IL1a_1 of the first contact insulating layer 161 may have a flat shape. In various example embodiments, the upper surface of the first flat portion IL1a_1 of the first contact insulating layer 161 may be disposed on a level lower than a level of an upper surface of the first gate electrode portion 130a. An upper surface of the first flat portion IL2a _1 of the second contact insulating layer 162 may be disposed on the same level as an upper surface of the second gate electrode portion 130b.

Since the first protrusions IL1a_2 and IL2a_2 of the first and second contact insulating layers 161 and 162 protrude toward the interlayer insulating layer 120, a thickness of the interlayer insulating layer 120 in contact with a lower portion of the first flat portions IL1a_1 and IL2a_1 may be greater than a thickness of the interlayer insulating layer 120 in contact with a lower portion of the first protrusions IL1a_2 and IL2a_2.

In various example embodiments, the second protrusions IL1b_2, IL2b_2 may extend from the second flat portion IL1b_1, IL2b_1 and may have a tapered shape of which the thickness in the third direction (Z-direction) gradually increases toward the vertical extension portion 170V. The third protrusions IL1b_3 and IL2b_3 may each extend from an end of the respective second protrusion IL1b_2, IL2b_2, and may each have a height smaller than the height in the third direction (Z-direction) of the end of the respective second protrusion IL1b_2, IL2b_2.

A height of the first contact insulating layer 161 in the third direction (Z-direction) measured on the same axis in the third direction (Z-direction) may be smaller than the height of a second contact insulating layer 162 in the third direction (Z-direction).

A distance from an upper surface of the second flat portion IL1b_1 of the first contact insulating layer 161 to an upper surface of the first flat portion IL1a_1 may be smaller than a distance from a lower surface of the second flat portion IL1b_1 of the first contact insulating layer 161 to a lower surface of the first flat portion IL1a_1. An upper surface of the first flat portion IL1a_1 of the first contact insulating layer 161 may be partially etched during the process of manufacturing the semiconductor device 100a and may have a flat one surface.

A distance from an upper surface of the second flat portion IL2b_1 of the second contact insulating layer 162 to an upper surface of the first flat portion IL2a_1 may be substantially the same as a distance from a lower surface of the second flat portion IL2b_1 of the second contact insulating layer 162 to a lower surface of the first flat portion IL2a_1.

The conductive liner 173 may extend to a region between the vertical extension portion 170V and the first and second contact insulating layers 161 and 162 and to a region between the vertical extension portion 170V and the interlayer insulating layers 120 from a region between the horizontal extension portion 170H and the first flat portion IL1a_1 of the first contact insulating layer 161. The conductive liner 173 may be disposed according to a surface profile of the third protrusion IL1b_3 protruding toward the vertical extension portion 170V. The conductive liner 173 may be disposed according to a surface profile of unevenness of a sidewall of the vertical extension portion 170V by a difference in etch speed between the first insulating patterns IL1a and IL2a of the first and second contact insulating layers 161, 162 and the second insulating patterns IL1b and IL2b in the process of manufacturing the semiconductor device.

The second insulating patterns IL1b and IL2b may include respective first voids 161V and second voids 162V.

The second insulating pattern IL1b of the first contact insulating layer 161 may include first voids 161V. The first voids 161V may include a 1-1 void 161Va and a 1-2 void 161Vb spaced apart from the 1-1 void 161Va in the horizontal direction and adjacent to the vertical extension portion 170V. In various example embodiments, the 1-1 void 161Va and the 1-2 void 161Vb may be spaced apart from each other in the horizontal direction with the second protrusion IL1b_2 of the first contact insulating layer 161 interposed therebetween. The 1-1 void 161Va may be disposed in the second flat portion IL1b_1, and the 1-2 void 161Vb may be disposed in the third protrusion IL1b_3.

The second insulating pattern IL2b of the second contact insulating layer 162 may include second voids 162V. The second voids 162V may include a 2-1 void 162Va and a 2-2 void 162Vb spaced horizontally from the 2-1 void 162Va and adjacent to the vertical extension portion 170V. In various example embodiments, the 2-1 void 162Va and the 2-2 void 162Vb may be spaced apart from each other in the horizontal direction with the second protrusion IL2b_2 of the second contact insulating layer 162 interposed therebetween. The 2-1 void 162Va may be disposed in the second flat portion IL2b_1, and the 2-2 void 162Vb may be disposed in the third protrusion IL2b_3.

The first void 161V and the second void 162V may be void spaces not filled with an insulating material. In the process of forming the second insulating patterns IL1b and IL2b, the 1-1 void 161Va and the 2-1 void 162Va may be formed in the second flat portions IL1b_1 and IL2b_1 disposed between the first flat portions IL1a_1 and IL2a_1, respectively, by a narrow and deep shape between the first flat portions IL1a_1, IL2a_1 of the first insulating patterns IL1a and IL2a. During the manufacturing process, a 1-2 void 161Vb and a 2-2 void 162Vb may be disposed and/or formed in the third protrusions IL1b_3 and IL2b_3, respectively, disposed in the narrow and deep shape.

By allowing the first and second contact insulating layers 161 and 162 to have a protruding shape, protruding toward the interlayer insulating layers 120, the first insulating pattern IL1a, IL2a may include first flat portions IL1a_1, IL2a_1 and first protrusions IL1a_2 and IL2a_2 extending from the first flat portions IL1a_1, IL2a_1, corresponding to a surface profile. Accordingly, the second protrusions IL1b_2, IL2b_2 of the second insulating pattern IL1b and IL2b may have a tapered shape of which a thickness increases toward the vertical extension portion 170V to correspond to the shape of the first protrusions IL1a _2 and IL2a_2, and the first void 161V and the second void 162V may be formed in the second insulating pattern IL1b and IL2b with respect to the second protrusions IL1b_2 and IL2b_2.

Lengths of the 1-1 void 161Va and the 2-1 void 162Va in the horizontal direction may be larger respectively than lengths of the 1-2 void 161Vb and the 2-2 void 162Vb in the horizontal direction.

The first insulating patterns IL1a and IL2a and the second insulating patterns IL1b and IL2b may include an insulating material. In various example embodiments, the first insulating patterns IL1a and IL2a may include a first insulating material and the second insulating patterns IL1b and IL2b may include a second insulating material different from the first insulating material. For example, the first insulating patterns IL1a and IL2a may include silicon oxide, and the second insulating patterns IL1b and IL2b may include silicon nitride.

In various example embodiments, a semiconductor device may include a first contact insulating layer 161 disposed between the first gate electrode portion 130a and the vertical extension portion 170V and a second contact insulating layer 162 disposed between the second gate electrode portion 130b and the vertical extension portion 170V. The second contact insulating layers 162 may include a first insulating pattern IL2a having a first protrusion protruding toward the interlayer insulating layer 120, and a second insulating pattern IL2b disposed between the first insulating patterns IL2a and having a second protrusion having a tapered shape to correspond to the first protrusion. Accordingly, with respect to the tapered shape, the 2-1 voids 161Va and 162Va and the 2-2 voids 161Vb and 162Vb spaced apart from each other in the horizontal direction may be formed in the second insulating pattern IL2b. Even when the 2-2 void 162Vb adjacent to the vertical extension portion 170V is deformed or broken during the process of manufacturing a semiconductor device, the 2-1 void 162Va adjacent to the second gate electrode portions 130b may be protected with respect to the second protrusion of the second insulating pattern IL2b, having the tapered shape. That is, since the contact plug 170 and the second gate electrode portion 130b may be normally insulated from each other through the second contact insulating layer 162, a semiconductor device having improved reliability may be provided.

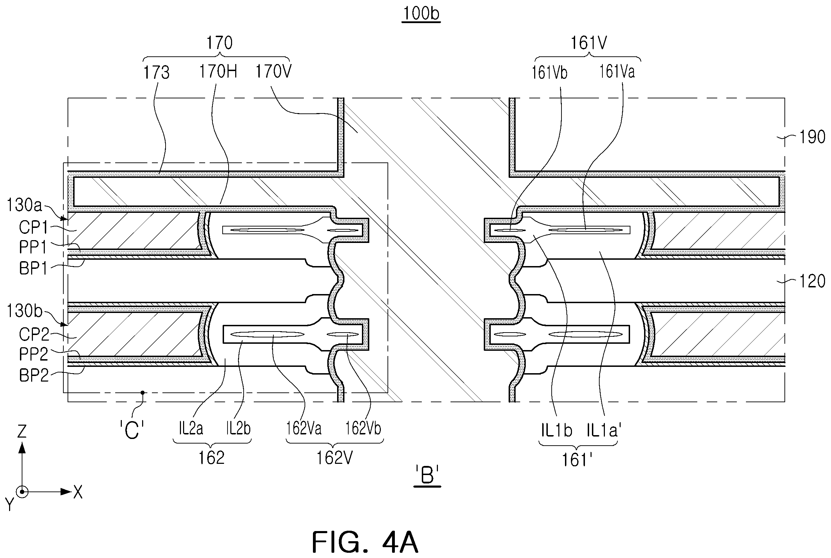

FIGS. 4A to 4C are enlarged diagrams illustrating various example embodiments of region B of the semiconductor device illustrated in FIG. 2.

Referring to FIG. 4A, in a semiconductor device 100b, the components other than the first contact insulating layer 161' may be the same as or correspond to the components illustrated in FIG. 3A. Among the other components other than the first contact insulating layer 161', overlapping descriptions of the components the same as or corresponding to the examples illustrated in FIG. 3A will not be provided.

Referring to FIG. 4A, the first contact insulating layer 161' may include a first insulating pattern IL1a' and a second insulating pattern IL1b. An upper surface of the first insulating pattern IL1a' may be disposed on the same level as an upper surface of the first gate electrode portion 130a. The conductive liner 173 may be flat without a step difference on the first gate electrode portion 130a and the first contact insulating layer 161.

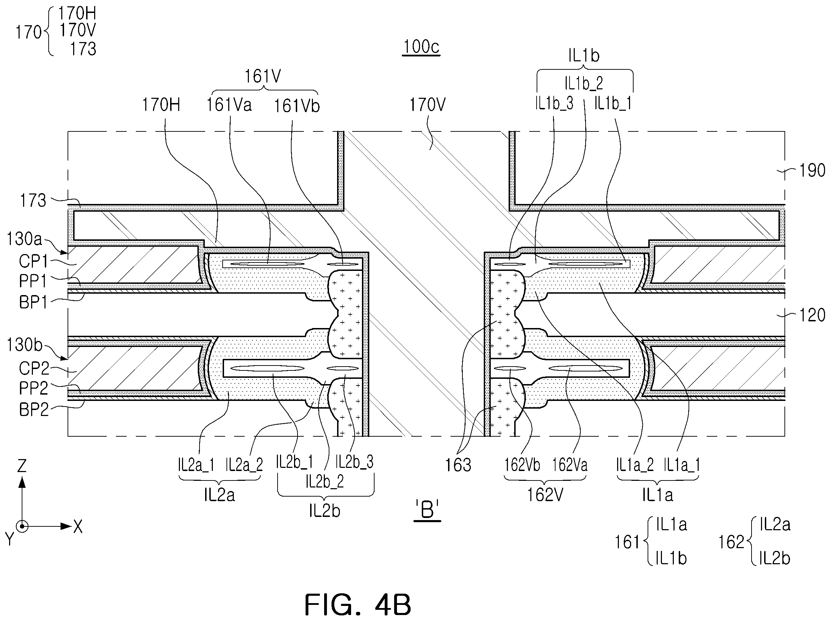

Referring to FIG. 4B, in a semiconductor device 100c, the components other than a sealing pattern 163 may be the same as or correspond to the components illustrated in FIG. 3A. Among the other components other than the sealing pattern 163, overlapping descriptions of the components the same as or corresponding to the examples illustrated in FIG. 3A will not be provided.

The first insulating patterns IL1a and IL2a and the second insulating patterns IL1b and IL2b may include different insulating materials, the first insulating patterns IL1a and IL2a exposed toward the vertical extension portion 170V and the third protrusions IL1b_3 and IL2b_3 of the second insulating pattern IL1b and IL2b protruding toward the vertical extension portion 170V may have different levels in the third direction (Z-direction). In various example embodiments, the third protrusions IL1b_3 and IL2b_3 of the second insulating patterns IL1b and IL2b may protrude toward the vertical extension portion 170V with respect to the first flat portions IL1a_1, IL2a_1 of the first insulating patterns IL1a and IL2a.

The sealing pattern 163 may be in contact with a lower portion of the third protrusions IL1b_3 and IL2b_3 of the second insulating pattern IL1b and IL2b, and may extend to a region between the first protrusions IL1a_2 and IL2a_2 of the first insulating patterns IL1a and IL2a and the vertical extension portion 170V and between the interlayer insulating layers 120 and the vertical extension portion 170V. The sealing pattern 163 may be disposed to eliminate unevenness (or a step difference) between the first and second contact insulating layers 161, 162 and the vertical extension portion 170V.

The sealing pattern 163 may include an insulating material, for example, may include silicon oxide, silicon nitride, or silicon oxynitride. In various example embodiments, the sealing pattern 163 may include an insulating material the same as a material of the second insulating patterns IL1b and IL2b. For example, the sealing pattern 163 may include silicon nitride. In this case, the interfacial surface between the sealing pattern 163 and the second insulating patterns IL1b and IL2b may be indistinct. That is, the sealing pattern 163 and the second insulating patterns IL1b and IL2b may extend to a region between the first insulating pattern IL1a of the first contact insulating layer 161 and the vertical extension portion 170V, to a region between the interlayer insulating layer 120 and the vertical extension portion 170V and to a region between the first insulating patterns IL2a of the second contact insulating layer 162 and may be integrated with each other. The second insulating pattern IL1b of the first contact insulating layer 161 and the second insulating pattern IL2b of the second contact insulating layer 162 may be integrated with each other.

The conductive liner 173 may extend from a region between the horizontal extension portion 170H and the first contact insulating layer 161 to a region between one side surface of the second insulating pattern IL1b and IL2b and the vertical extension portion 170V, and to a region between the sealing pattern 163 and the vertical extension portion 170V. The conductive liner 173 may be disposed along a side profile coplanar with the vertical extension portion of 170V.

The semiconductor device according to various example embodiments may include a sealing pattern 163 filling unevenness or a curved portion between the first and second contact insulating layers 161 and 162 and the vertical extension portion 170V, such that the vertical extension portion 170V may have a flat sidewall structure. Accordingly, an electric field concentration phenomenon caused by an uneven sidewall structure may be addressed, and the defect of voids in the contact plug 170 may be reduced.

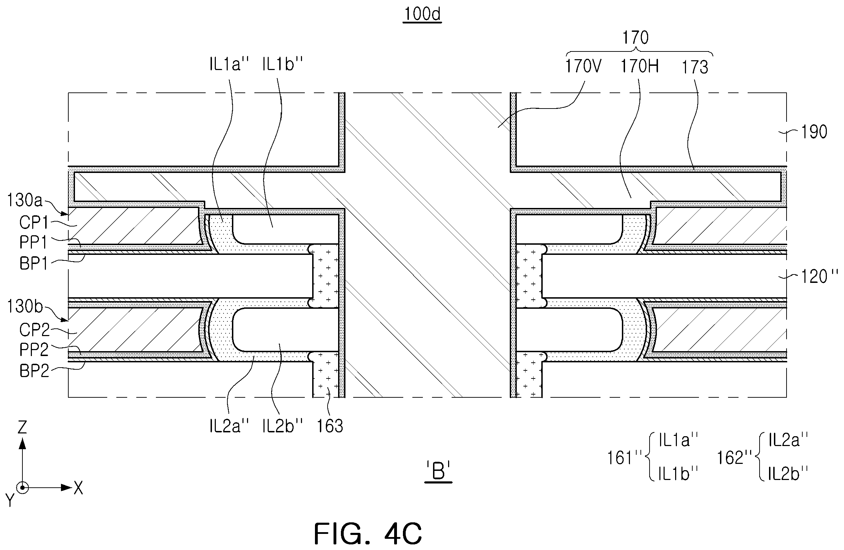

Referring to FIG. 4C, in a semiconductor device 100d, the components other than the first and second contact insulating layers 161" and 162", the interlayer insulating layer 120" and the sealing pattern 163 may be the same as the components illustrated in FIG. 3A. Among the components other than the first and second contact insulating layers 161" and 162", and the sealing pattern 163, overlapping descriptions of the components the same as or corresponding to the examples illustrated in FIG. 3A will not be provided.

The first and second contact insulating layers 161" and 162" may include first insulating pattern IL1a" and IL2a" and second insulating pattern IL1b" and IL2b" having a portion surrounded by the first insulating pattern IL1a" and IL2a". A height of the first contact insulating layer 161" in the third direction (Z-direction) may be smaller than a height of the second contact insulating layer 162" in the third direction (Z-direction).

The first contact insulating layer 161" may include a first insulating pattern IL1a" and a second insulating pattern IL1b" having a portion surrounded by the first insulating pattern IL1a". An upper surface of the second insulating pattern IL1b" may be in contact with the conductive liner 173. The first insulating pattern IL1a" may cover a portion of a side surface and a lower surface of the second insulating pattern IL1b". The second insulating pattern IL1b" may include a portion protruding toward the vertical extension portion 170V, formed during the manufacturing process due to a difference in insulating materials from the first insulating pattern IL1a". In various example embodiments, the lower surface of the first contact insulating layer 161" may be disposed on the same level as the lower surface of the first gate electrode portion 130a.

The second contact insulating layer 162" may include a first insulating pattern IL2a" and a second insulating pattern IL2b" having a portion surrounded by the first insulating pattern IL2a". The second insulating pattern IL2b" may include a portion protruding toward the vertical extension portion 170V. An upper surface of the second contact insulating layer 162" may be disposed on the same level as an upper surface of the second gate electrode portion 130b. The lower surface of the second contact insulating layer 162" may be disposed on the same level as the lower surface of the second gate electrode portion 130b.

The sealing pattern 163 may surround the second insulating patterns IL1b" and IL2b" protruding toward the vertical extension portion 170V, and may extend to a region between the interlayer insulating layer 120 and the vertical extension portion 170V. The sealing pattern 163 may fill unevenness and/or a curved portion between the first and second contact insulating layers 161" and 162" and the vertical extension portion 170V.

The conductive liner 173 may extend from a region between the horizontal extension portion 170H and the first contact insulating layer 161" to a region between side surfaces of the second insulating pattern IL1b", IL2b" and to a region between the sealing pattern 163 and the vertical extension portion 170V and may be disposed along a surface profile. The conductive liner 173 may cover a flat one surface between the vertical extension portion 170V and the sealing pattern 163.

A thickness of the interlayer insulating layer 120 in the third direction (Z-direction) may be substantially uniform.

The semiconductor device according to various example embodiments may include a sealing pattern 163 filling unevenness or curved portion between the first and second contact insulating layers 161" and 162" and the vertical extension portion 170V, such that the vertical extension portion 170V may have a flat sidewall structure. Accordingly, an electric field concentration phenomenon caused by the uneven sidewall structure may be addressed and the defect of voids in the contact plug 170 may be reduced.

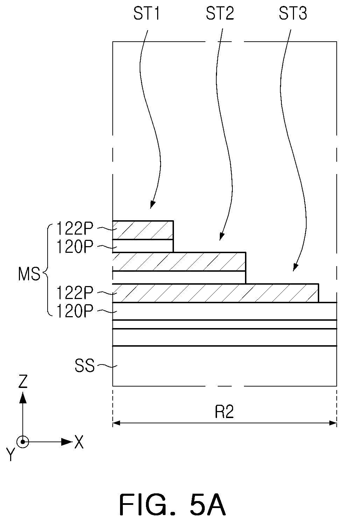

FIGS. 5A to 5F are cross-sectional diagrams illustrating various example embodiments of a method of manufacturing a semiconductor device in FIG. 1B. The method of manufacturing a semiconductor device will be described with respect to region D in FIG. 1B with reference to FIGS. 5A to 5F.

Referring to FIG. 5A, a stack structure MS may be formed on a plate layer SS.

The stack structure MS may include interlayer insulating layers 120P and sacrificial insulating layers 122P. The interlayer insulating layers 120P and the sacrificial insulating layers 122P may be stacked alternately in the third direction (Z-direction). The stack structure MS may form a staircase form by patterning the interlayer insulating layers 120P and the sacrificial insulating layers 122P. Each of the sacrificial insulating layers 122P may form a pair with one of the interlayer insulating layers 120P adjacent thereto in the third direction (Z-direction) and may extend in the first direction (X-direction). The pair provided by the interlayer insulating layers 120P and the sacrificial insulating layers 122P may extend to different lengths in the first direction (X-direction) in the second region R2 and may form a staircase structure. A plurality of pad regions ST1-ST3 may be provided by the staircase structure. By forming the plurality of pad regions ST1-ST3, at least a partial region of the sacrificial insulating layer 122P disposed in the lower portion in the third direction (Z-direction) may be exposed.

The interlayer insulating layer 120P and the sacrificial insulating layers 122P may be formed of a material having a desired (and/or alternatively predetermined) etch selectivity. In various example embodiments, the preliminary interlayer insulating layer 120P may include at least one of a silicon oxide layer and a silicon nitride layer, and the sacrificial insulating layer 122P may include at least one of a silicon layer, a silicon oxide layer, a silicon carbide layer, and a silicon nitride layer. However, example embodiments are not limited thereto. For example, the material thereof may be different from the interlayer insulating layer 120P. For example, when the interlayer insulating layer 120P is a silicon oxide layer, the sacrificial insulating layer 122P may be a silicon nitride layer.

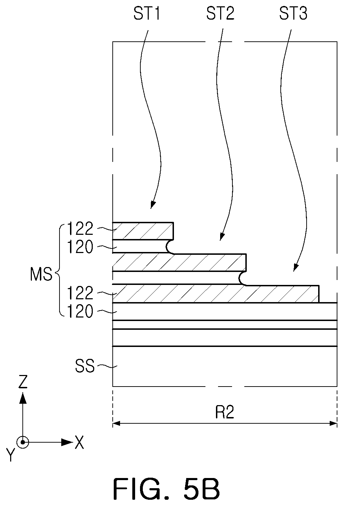

Referring to FIG. 5B, a portion of the preliminary interlayer insulating layers 120P may be recessed and may form the interlayer insulating layer 120. By flowing the etching solution through one side surface of the preliminary interlayer insulating layers 120P having different lengths in the staircase structure, only a portion of the preliminary interlayer insulating layer 120P disposed in the lower portion of the plurality of pad regions ST1-ST3 may be selectively removed, thereby forming an interlayer insulating layer 120.

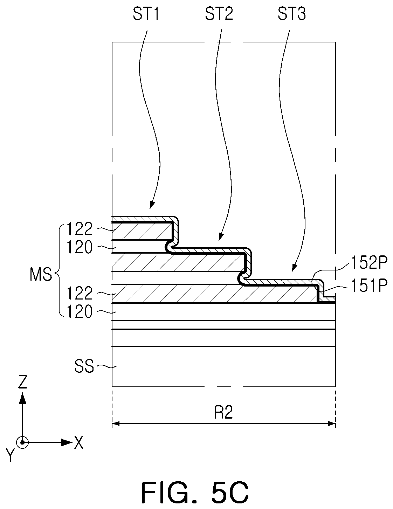

Referring to FIG. 5C, pad structures 151P and 152P may be formed on the sacrificial insulating layers 122. The pad structures 151P and 152P may include a first sacrificial pad layer 151P and a second sacrificial pad layer 152P formed in order on the sacrificial insulating layers 122.

The first sacrificial pad layer 151P may be one of a silicon film, a silicon oxide film, a silicon carbide film, and a silicon nitride film. However, example embodiments are not limited thereto. For example, the material thereof may be different from a material of the sacrificial insulating layer 122. For example, when the sacrificial insulating layers 122 are silicon nitride layers, the first sacrificial pad layer 151P may include a silicon oxide layer. In various example embodiments, the first sacrificial pad layer 151P may include polysilicon.

A height of the first sacrificial pad layer 151P in the third direction (Z-direction) may be smaller than a height of the second sacrificial pad layer 152P in the third direction (Z-direction). For example, the height of the first sacrificial pad layer 151P may be about 5nm. The second sacrificial pad layer 152P may be about 17nm.

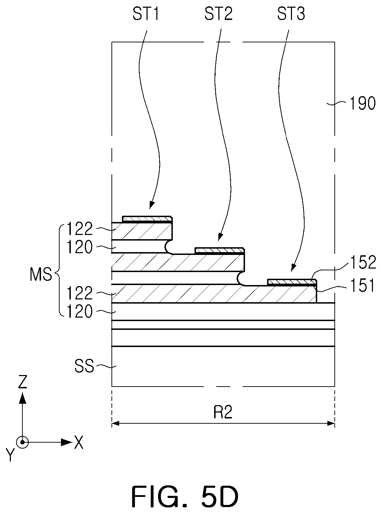

Referring to FIG. 5D, the first and second sacrificial pad layers 151P and 152P may be node-separated for each of the plurality of pad regions ST1-ST3 such that the interlayer insulating layer 120 may be exposed, and the first and second sacrificial pad layers 151 and 152 may be formed on the plurality of pad regions ST1-ST3. The first and second sacrificial pad layers 151 and 152 may be formed by a patterning process.

A cell region insulating layer 190 may be formed to cover the first and second sacrificial pad layers 151, 152 and the stack structure MS disposed on the plurality of pad regions ST1-ST3.

The first and second sacrificial pad layers 151 and 152 may be a region replaced with the horizontal extension portion (e.g., the horizontal extension portion 170H in FIG. 2) of a contact plug, which will be described later.

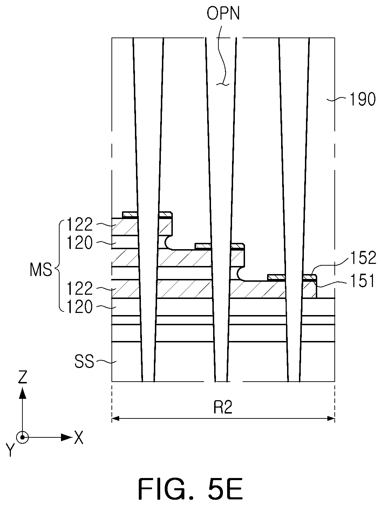

Referring to FIG. 5E, a through-hole OPN may be formed in the region in which the contact plug (e.g., the contact plug 170 in FIG. 1B) is formed in the second region R2.

In the second region R2, a through-hole OPN may be formed penetrating a staircase structure of the cell region insulating layer 190, the first and second sacrificial pad layers 151, 152, and the stack structure MS. The through-hole OPN may have a cylindrical hole shape.

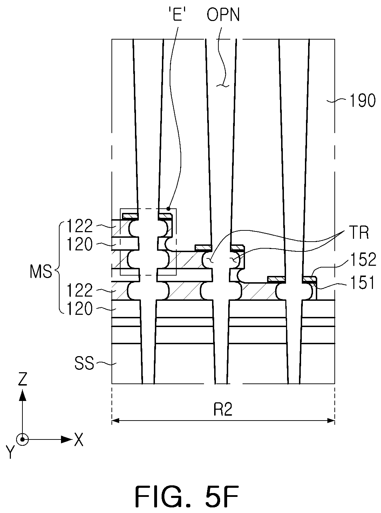

Referring to FIG. 5F, a trench TR may be formed by removing a portion of the sacrificial insulating layers 122 exposed through the through-hole OPN.

The trench TR may be formed by applying an etchant through the through-hole OPN and removing the sacrificial insulating layers 122 to a desired (and/or alternatively predetermined) length around the through-hole OPN. In another example, the trench TR may be formed through a dry etching process on a side surface of the sacrificial insulating layers 122 exposed through the through-hole OPN. A length of the trench TR may be formed in various manners.

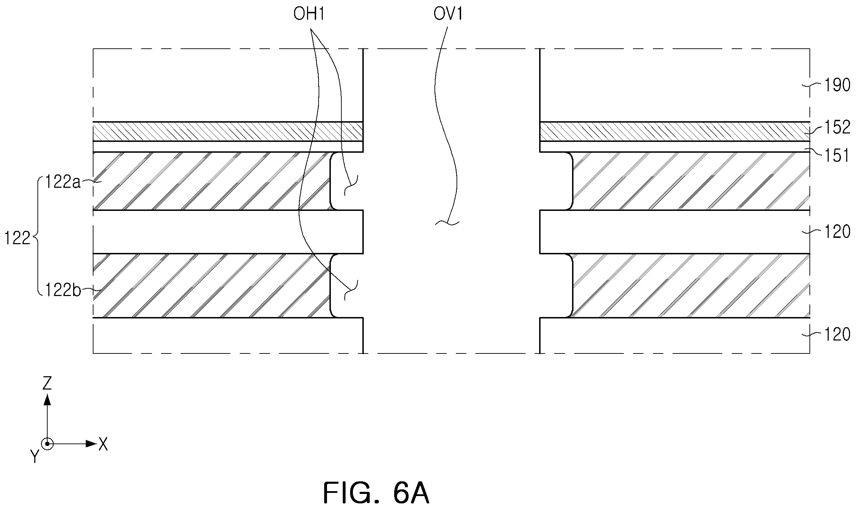

FIGS. 6A to 6J are cross-sectional diagrams illustrating various example embodiments of a method of manufacturing a semiconductor device in FIG. 3A.

FIG. 6A is an enlarged diagram illustrating region E of the semiconductor device in FIG. 5F according to various example embodiments. Referring to FIG. 6A, by applying the etchant through a first vertical through-hole OV1 penetrating the sacrificial insulating layers 122 and the interlayer insulating layer 120, a first horizontal tunnel layer OH1 may be formed by removing the sacrificial insulating layers 122 to a desired (and/or alternatively predetermined) length around the first vertical through-hole OV1.

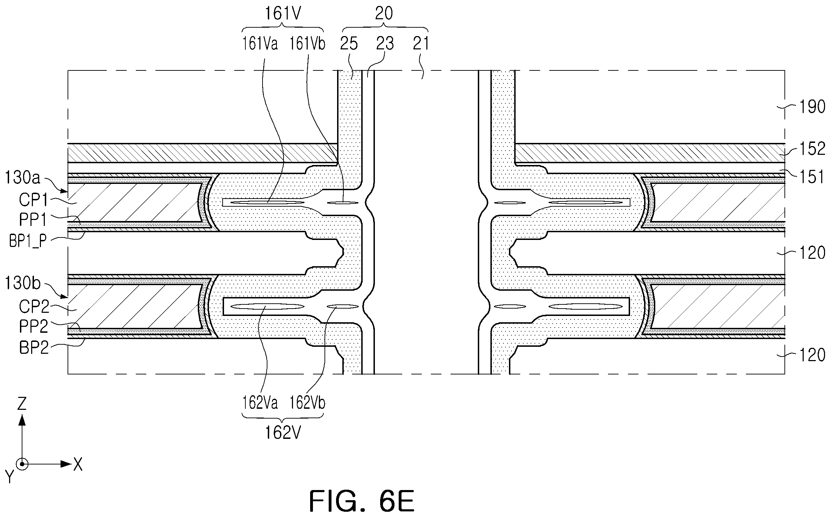

The sacrificial insulating layer 122 may include a first sacrificial insulating layer 122a disposed below the first sacrificial pad layer 151 and a second sacrificial insulating layer 122b disposed between interlayer insulating layers 120. The first sacrificial insulating layer 122a may be a region replaced by the first gate electrode portion (e.g., the first gate electrode portion 130a in FIG. 6E), which will be described later. The second sacrificial insulating layer 122b may be a region replaced by the second gate electrode portion (e.g., the second gate electrode portion 130b in FIG. 6E), which will be described later.

A height of the first sacrificial insulating layer 122a in the third direction (Z-direction) may be smaller than a height of the second sacrificial insulating layer 122b in the third direction (Z-direction). In the process of recessing a portion of the preliminary interlayer insulating layers 120P in FIG. 5B, a portion of an upper surface of the sacrificial insulating layers 122P disposed on a lower portion of the interlayer insulating layers 120P, and having an upper portion exposed for each of the plurality of pad regions ST1-ST3 may be etched. Accordingly, the first sacrificial insulating layer 122a has an exposed upper surface and the second sacrificial insulating layer 122b is covered by the interlayer insulating layer 120 and has an upper surface which is not exposed.

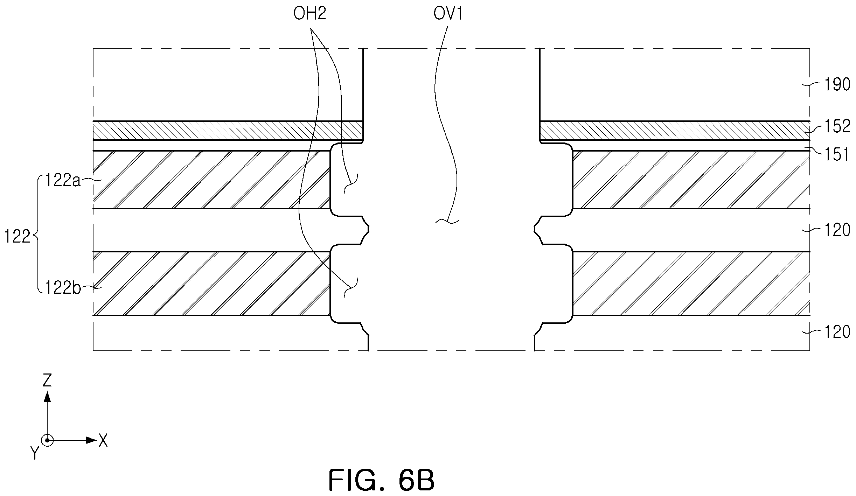

Referring to FIG. 6B, the first horizontal tunnel layer OH1 may be further enlarged in the third direction (Z-direction) toward the interlayer insulating layer 120 and the first sacrificial pad layer 151 and a second horizontal tunnel layer OH2 may be formed. A portion of the first sacrificial pad layer 151 overlapping the first horizontal tunnel layer OH1 may be etched in the third direction (Z-direction) using a dry etching process. The second horizontal tunnel layer OH2 may protrude toward the interlayer insulating layer 120 and the first sacrificial pad layer 151.

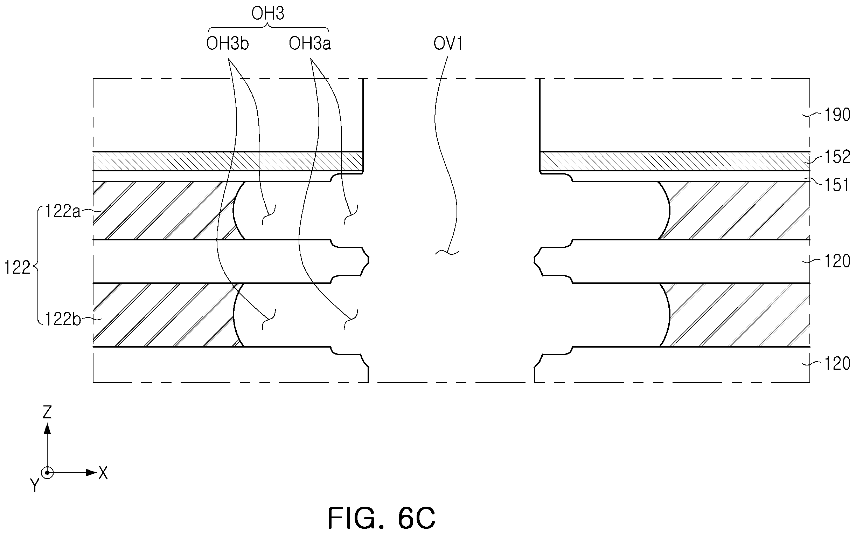

Referring to FIG. 6C, a third horizontal tunnel layer OH3 may be formed through a pull-back process or an etching process on a side surface of the sacrificial insulating layer 122 exposed through the second horizontal tunnel layer OH2. The third horizontal tunnel layer OH3 may include a 3-1 horizontal tunnel layer OH3a having an enlarged portion toward the first sacrificial pad layer 151 and the interlayer insulating layer 120 and a 3-2 horizontal tunnel layer OH3b extending horizontally toward the sacrificial insulating layer 122.

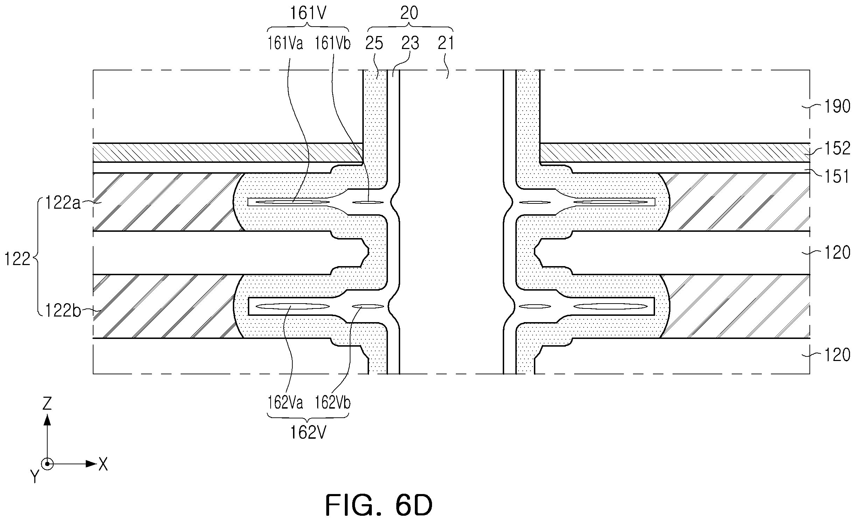

Referring to FIGS. 6C and 6D, an insulating structure 20 may be formed in the first vertical through-hole OV1 and the third horizontal tunnel layer OH3 connected to the first vertical through-hole OV1.

The insulating structure 20 may include a first insulating liner 25 extending into a side surface of the first vertical through-hole OV1 and the third horizontal tunnel layer OH3 and formed through a sequential deposition process, a second insulating liner 23, and a sacrificial liner 21. The deposition process may include an atomic layer deposition (ALD) process. A thickness of the sacrificial liner 21 may be greater than each of thicknesses of the first and second insulating liners 25 and 23.

The first insulating liner 25 may have a substantially uniform thickness, may extend from a side surface of the first vertical through-hole OV1 into the third horizontal tunnel layer OH3 and may be formed conformally according to a surface profile of the third horizontal tunnel layer OH3. The second insulating liner 23 may be deposited on the first insulating liner 25. That is, the second insulating liner 23 may be deposited by extending to a region between the first insulating liner 25 in the third horizontal tunnel layer OH3 on the first insulating liner 25 formed on a side surface of the first vertical through-hole OV1. The sacrificial liner 21 may be deposited on the second insulating liner 23 disposed on the side surface of the first vertical through-hole OV1.

The first insulating liner 25 may include a first insulating material, and the second insulating liner 23 may include a second insulating material different from the first insulating material. The sacrificial liner 21 may include carbon (C) or polysilicon. However, example embodiments are not limited thereto. For example, the first insulating liner 25 may include silicon oxide, and the second insulating liner 23 may include silicon nitride.

The second insulating liner 23 may be formed between the first sacrificial insulating layer 122a and the first insulating liner 25 adjacent to the 3-2 horizontal tunnel layer OH3b, the 1-1 void 161Va may be formed in a process of forming the second insulating liner 23 between the first insulating liners 25 formed in the 3-2 horizontal tunnel layer OH3b adjacent to the first sacrificial insulating layer 122a, and the 1-2 void 161Vb may be formed between the first insulating liner 25 in the 3-1 horizontal tunnel layer OH3a.

The 2-1 void 162Va may be formed in a process of forming the second insulating liner 23 between the first insulating liners 25 formed in the 3-2 horizontal tunnel layer OH3b adjacent to the second sacrificial insulating layer 122b, and the 2-2 void 162Vb may be formed in a process of forming the second insulating liner 23 between the first insulating liner 25 in the 3-1 horizontal tunnel layer OH3a.

The thickness of the second insulating liner 23 in the third horizontal tunnel layer OH3 adjacent to the first sacrificial insulating layer 122a may be smaller than the thickness of the second insulating liner 23 in the third horizontal tunnel layer OH3 adjacent to the second sacrificial insulating layer 122b.

Referring to FIGS. 6D and 6E, by removing the sacrificial insulating layers 122, the first and second gate electrode portions 130a and 130b may be formed. The sacrificial insulating layers 122 may be removed by a wet etching process. Before forming the first and second gate electrode portions 130a and 130b, the first blocking layer BP1_P may be deposited in a space in which the first sacrificial insulating layer 122a has been removed, and the second blocking layer BP2 may be deposited in a space from which the second sacrificial insulating layer 122b has been removed. The first blocking layer BP1_P and the second blocking layer BP2 may be formed conformally according to the surface profile of the internal wall of the space from which the sacrificial insulating layers 122 have been removed. The first blocking layer BP1_P and the second blocking layer BP2 may have a desired (and/or alternatively predetermined) thickness. The first blocking layer BP1_P and the second blocking layer BP2 may include metal oxide. For example, the first blocking layer BP1_P and the second blocking layer BP2 may include aluminum nitride (AlN), aluminum oxynitride (AlON), aluminum oxide (AlO), or aluminum oxide carbide (AlOC). However, example embodiments are not limited thereto.

The first gate electrode portion 130a may be formed on the first blocking layer BP1_P, and the second gate electrode portion 130b may be formed on the second blocking layer BP2. In various example embodiments, the first barrier layer PP1 and the first conductive layer CP1 may be deposited in order on the first blocking layer BP1_P. The second barrier layer PP2 and the second conductive layer CP2 may be deposited in order on the second blocking layer BP2. In various example embodiments, the first and second barrier layers PP1 and PP2 may be formed conformally according to the surface profiles of the first blocking layer BP1_P and the second blocking layer BP2.

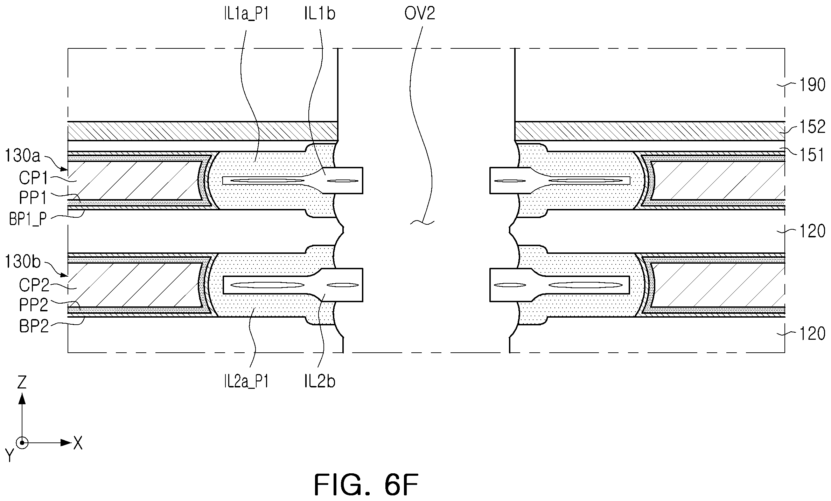

Referring to FIGS. 6E and 6F, the insulating structure 20 surrounding a second vertical through-hole OV2 may be removed. An etching process including removing the sacrificial liner 21 from the second vertical through-hole OV2 and further removing a portion of the first and second insulating liners 25 and 23 may be performed. The second insulating liner 23 may have an etch rate lower than the first insulating liner 25. In various example embodiments, the first insulating liner 25 may be etched, such that the first insulating pattern IL1a_P1 and IL2a_P1 may remain in the third horizontal tunnel layer OH3, and the second insulating liner 23 may be etched, such that the second insulating pattern IL1b and IL2b including a portion protruding from an end of the first insulating pattern IL1a_P1 and IL2a_P1 between the first insulating pattern IL1a_P1 and IL2a_P1 toward the second vertical through-hole OV2 may remain. In various example embodiments, an upper surface of the first insulating pattern IL1a_P1 and IL2a _P1 may be disposed on the same level as an upper surface of the first and second gate electrode portions 130a and 130b.

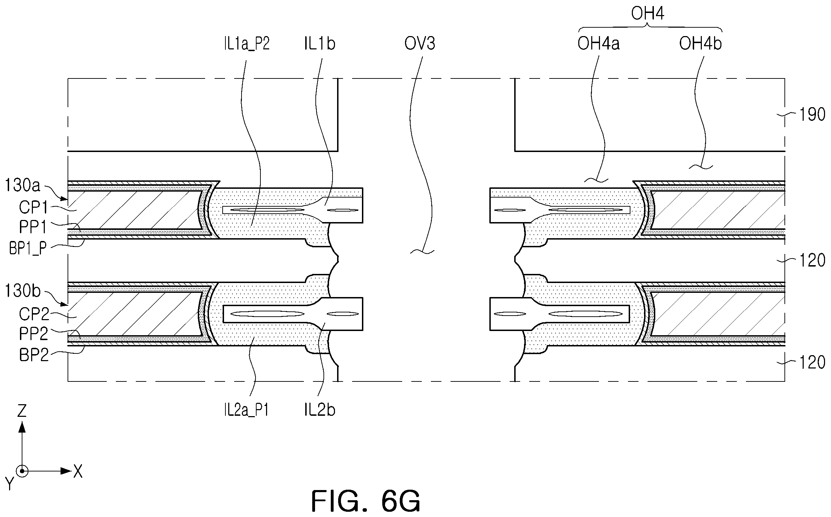

Referring to FIG. 6G, a fourth horizontal tunnel layer OH4 may be formed by removing the first and second sacrificial pad layers 151 and 152. The first and second sacrificial pad layers 151 and 152 may be removed by an etching process. The etching process may include a wet etching and/or dry etching process.

In the process of removing the first and second sacrificial pad layers 151 and 152, the upper surface of the first insulating pattern IL1a_P1 in contact with the first sacrificial pad layer 151 may be partially etched and the first insulating pattern IL1a _P2 may be formed. An upper surface of the first insulating pattern IL1a_P2 may have a level lower than a level of the upper surface of the first gate electrode portion 130a.

The first insulating pattern IL1a_P2 may be exposed through a 4-1 horizontal tunnel layer OH4a, and the first blocking layer BP1_P covering the first gate electrode portion 130a may be exposed through a 4-2 horizontal tunnel layer OH4b.

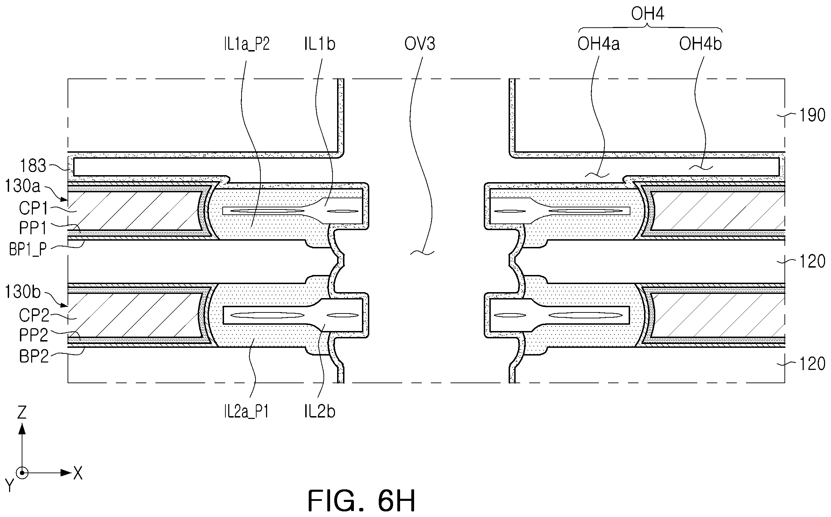

Referring to FIG. 6H, a sacrificial film 183 covering the side surface of a third vertical through-hole OV3 and the fourth horizontal tunnel layer OH4 may be formed. The sacrificial film 183 may include a material having etch selectivity with respect to the interlayer insulating layer 120. For example, the sacrificial film 183 may include silicon nitride.

In various example embodiments, the process of forming the sacrificial film 183 according to a surface profile of a side surface of the third vertical through-hole OV3 and a surface profile of the fourth horizontal tunnel layer OH4 may not be provided. In this case, after the process of removing the first and second sacrificial pad layers 151 and 152, a conductive liner 173 may be deposited according to surface profiles of the third vertical through-hole OV3 and the fourth horizontal tunnel layer OH4.

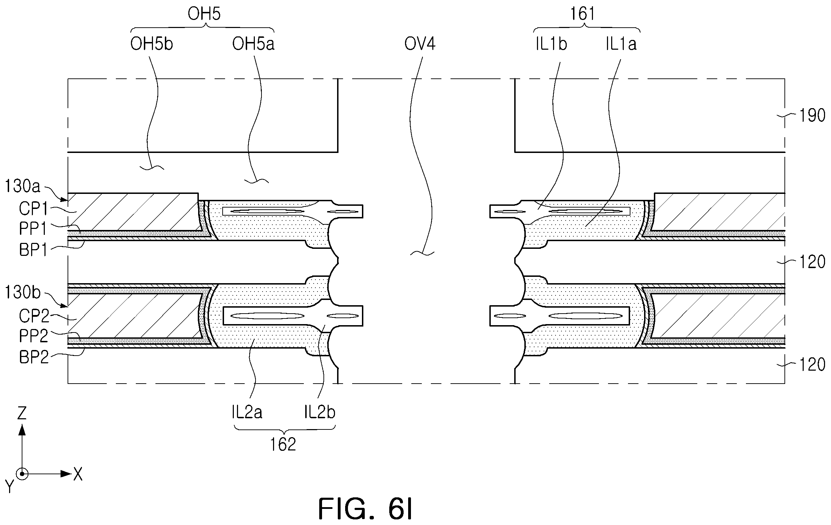

Referring to FIG. 6I, the first blocking layer BP1_P exposed through the sacrificial film 183 and the fourth horizontal tunnel layer OH4 may be removed. In various example embodiments, the sacrificial film 183 disposed according to the surface profile of the side surface of the third vertical through-hole OV3 and the fourth horizontal tunnel layer OH4 may be removed through an etching process. In the process of removing the sacrificial film 183, a portion of the upper surface of first insulating pattern IL1a_P2 may be etched, thereby forming the first insulating pattern IL1a. The upper surface of the first insulating pattern IL1a may be exposed through a 5-1 horizontal tunnel layer OH5a. In various example embodiments, as the first blocking layer BP1_P exposed through the fourth horizontal tunnel layer OH4 is removed, an upper surface of the first gate electrode portion 130a may be exposed through a 5-2 horizontal tunnel layer OH5b. In various example embodiments, the first barrier layer PP1 in contact with the upper surface of the first blocking layer BP1_P may be removed along with the first blocking layer BP1_P. However, example embodiments thereof are not limited thereto, and the first barrier layer PP1 in contact with the upper surface of the first blocking layer BP1_P may not be removed. In this case, a portion of the first barrier layer PP1 in contact with the upper surface of the first blocking layer BP1_P may be removed or remain through a separate process.

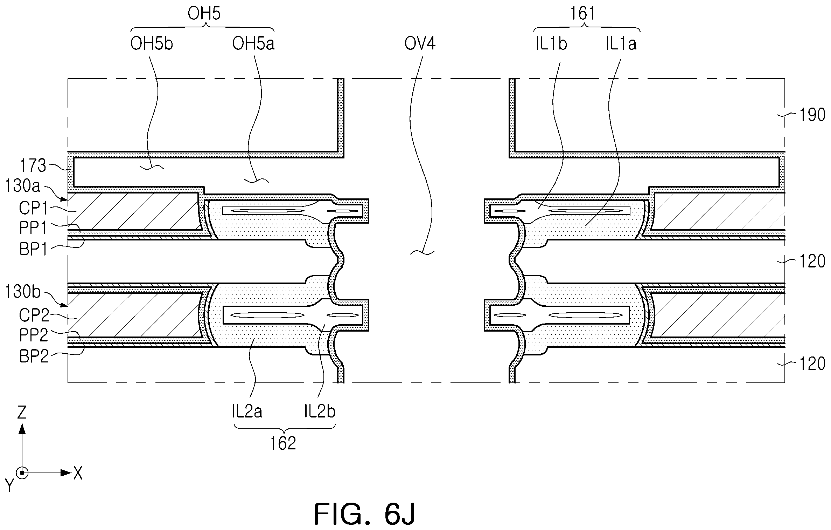

Referring to FIG. 6J, the conductive liner 173 may be deposited according to the surface profile of the fourth vertical through-hole OV4 and a fifth horizontal tunnel layer OH5. The conductive liner 173 may cover the upper surface of the first gate electrode portion 130a and the upper surface of the first contact insulating layer 161 exposed through the fifth horizontal tunnel layer OH5. The conductive liner 173 may extend from the upper surface of the first gate electrode portion 130a and the upper surface of the first contact insulating layer 161 along the side surfaces of the first and second contact insulating layers 161 and 162 and the side surface of the interlayer insulating layer 120.

Thereafter, referring to FIG. 3A, a contact plug 170 may be formed by depositing a conductive material in the fourth vertical through-hole OV4 and the fifth horizontal tunnel layer OH5.

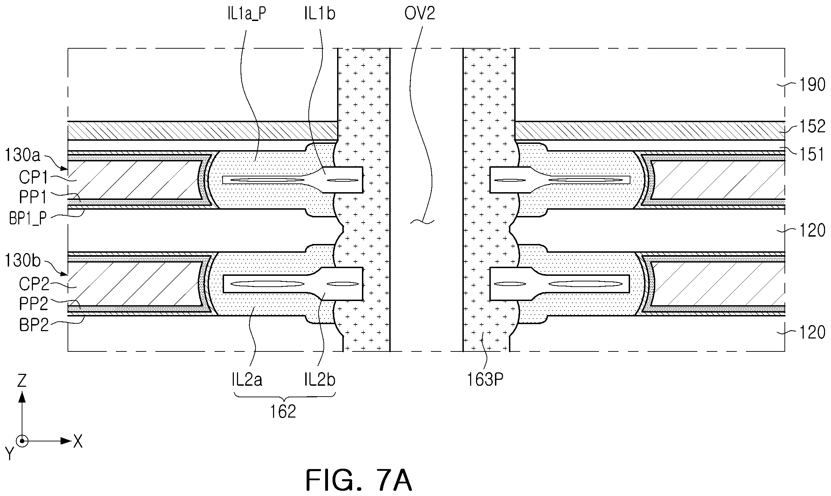

FIGS. 7A to 7C are cross-sectional diagrams illustrating various example embodiments of a method of manufacturing a semiconductor device in FIG. 4B.

FIGS. 7A to 7C may be performed in order as processes subsequent to the process of removing the insulating structure 20 surrounding the second vertical through-hole OV2 in FIG. 6F.

Referring to FIG. 7A, a sealing pattern 163P may be deposited on a side surface of the second vertical through-hole OV2. The sealing pattern 163P may fill the space in a step difference between the first insulating pattern IL1a_P and IL2a exposed to the side surface of the second vertical through-hole OV2 and the second insulating pattern IL1b and IL2b and unevenness of the second contact insulating layer 162 by a difference in etching speeds in the process of removing the insulating structure 20 surrounding the second vertical through-hole OV2.

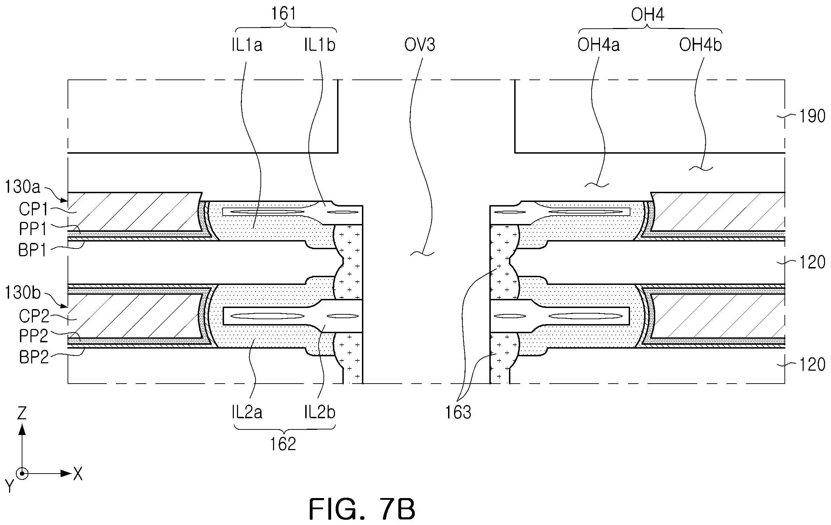

Referring to FIG. 7B, the fourth horizontal tunnel layer OH4 may be formed by removing the first and second sacrificial pad layers 151 and 152. By performing a trimming process on the sealing pattern 163P, the second insulating pattern IL2b may form a sealing pattern 163 exposing the side surface of IL2b.

The first and second sacrificial pad layers 151 and 152 may be removed by an etching process. The etching process may include a wet etching and/or dry etching process. In the process of removing the first and second sacrificial pad layers 151 and 152, an upper surface of the first insulating pattern IL1a_P in contact with the first sacrificial pad layer 151 may be partially etched, thereby forming the first insulating pattern IL1a.

Through the trimming process for sealing pattern 163P, the sealing pattern 163P disposed on a side surface of the first and second sacrificial pad layers 151, 152 and the second vertical through-hole OV2 in contact with the cell region insulating layer 190 is removed. The side surface of the second insulating patterns IL1b and IL2b may be exposed by partially etching the sealing pattern 163P in the horizontal direction on the lower surface of the second insulating patterns IL1b and IL2b protruding toward the third vertical through-hole OV3. The external side surface of the side surface and sealing pattern 163 of the second insulating patterns IL1b and IL2b exposed toward the third vertical through-hole OV3 may form a flat one surface on a level in the third direction (Z-direction).

After the process of removing the first and second sacrificial pad layers 151 and 152, one surface of the first blocking layer BP1_P may be exposed through the fourth horizontal tunnel layer OH4. The first blocking layer BP1 may be formed by removing the first blocking layer BP1_P exposed through the fourth horizontal tunnel layer OH4. As the first blocking layer BP1_P exposed through the fourth horizontal tunnel layer OH4 is removed, an upper surface of the first gate electrode portion 130a may be exposed. In various example embodiments, the first barrier layer PP1 in contact with the upper surface of the first blocking layer BP1_P may be removed along with the first blocking layer BP1_P. However, example embodiments thereof are not limited thereto, and the first barrier layer PP1 in contact with the upper surface of the first blocking layer BP1_P may not be removed in some examples.

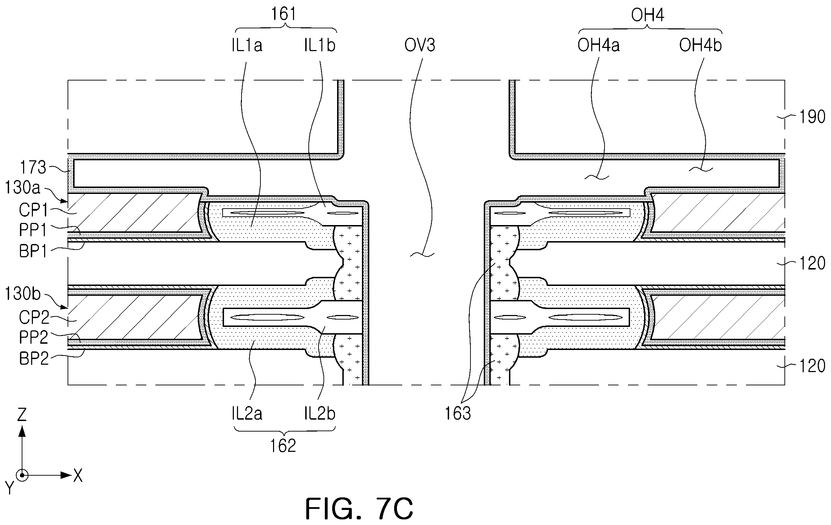

Referring to FIG. 7C, the conductive liner 173 may be deposited according to the surface profiles of the third vertical through-hole OV3 and the fourth horizontal tunnel layer OH4. The conductive liner 173 may cover the upper surface of the first gate electrode portion 130a and the upper surface of the first contact insulating layer 161 exposed through the fourth horizontal tunnel layer OH4. The conductive liner 173 may extend from the upper surface of the first gate electrode portion 130a and the upper surface of the first contact insulating layer 161 along the side surfaces of the second insulating patterns IL1b and IL2b and the side surfaces of the sealing pattern 163.

Thereafter, referring to FIG. 4B, the contact plug 170 may be formed by depositing a conductive material in the third vertical through-hole OV3 and the fourth horizontal tunnel layer OH4.

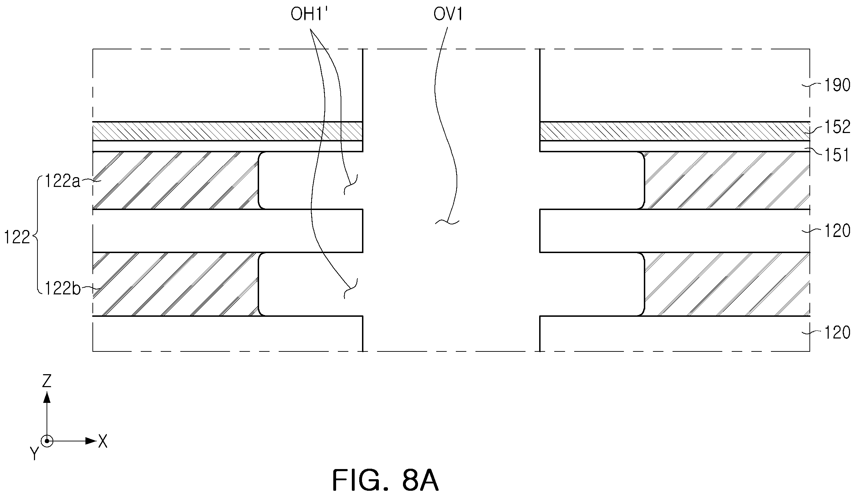

FIGS. 8A to 8G are cross-sectional diagrams illustrating various example embodiments of a method of manufacturing a semiconductor device in FIG. 4C.

FIG. 8A is an enlarged diagram illustrating region E of the semiconductor device in FIG. 5F according to other various example embodiments. Referring to FIG. 8A, by applying an etchant through the first vertical through-hole OV1 penetrating the sacrificial insulating layers 122 and the interlayer insulating layer 120, the sacrificial insulating layers 122 may be removed to a desired (and/or alternatively predetermined) length around the first vertical through-hole OV1 and the first horizontal tunnel layer OH1' may be formed.

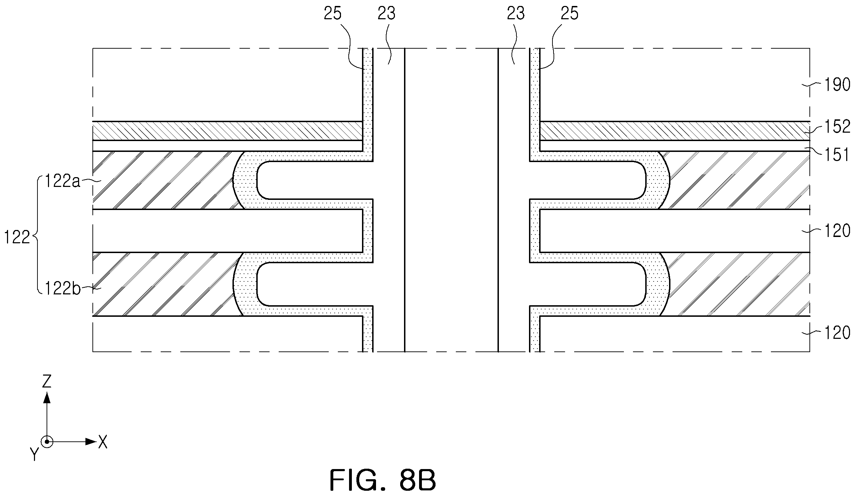

Referring to FIG. 8B, the first insulating liner 25 and the second insulating liner 23 may be formed in the first horizontal tunnel layer OH1' connected to the first vertical through-hole OV1, and formed in the first vertical through-hole OV1.

The first insulating liner 25 and the second insulating liner 23 may extend into the side surface of the first vertical through-hole OV1 and the first horizontal tunnel layer OH1' and may be formed in order through a deposition process.

The first insulating liner 25 may have a substantially uniform thickness, may extend from the side surface of the first vertical through-hole OV1 into the first horizontal tunnel layer OH1' and may be formed conformally according to a surface profile of the first horizontal tunnel layer OH1'. A second insulating liner 23 may be deposited on a first insulating liner 25. That is, by extending to a region between the first insulating liner 25 in the third horizontal tunnel layer OH3 on the first insulating liner 25 formed on the side surface of the first vertical through-hole OV1, the second insulating liner 23 may be deposited. The first insulating liner 25 may include a first insulating material, and the second insulating liner 23 may include a second insulating material different from the first insulating material.

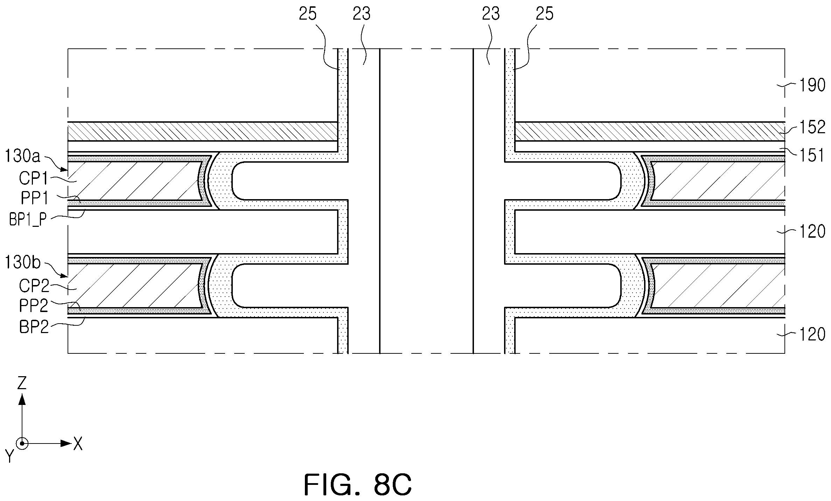

Referring to FIG. 8C, by removing the sacrificial insulating layers 122 first and second gate electrode portions 130a and 130b may be formed. The sacrificial insulating layers 122 may be removed by a wet etching process. Before forming the first and second gate electrode portions 130a and 130b, the first blocking layer BP1_P may be deposited in the space from which the first sacrificial insulating layer 122a has been removed, and the second blocking layer BP2 may be deposited in the space from which the second sacrificial insulating layer 122b has been removed. The first blocking layer BP1_P and second blocking layer BP2 may be formed conformally according to the surface profile of the internal wall of the space from which the sacrificial insulating layers 122 have been removed.

The first gate electrode portion 130a may be formed on the first blocking layer BP1_P, and the second gate electrode portion 130b may be formed on the second blocking layer BP2. In various example embodiments, the first barrier layer PP1 and the first conductive layer CP1 may be deposited in order on the first blocking layer BP1_P. The second barrier layer PP2 and the second conductive layer CP2 may be deposited in order on the second blocking layer BP2.

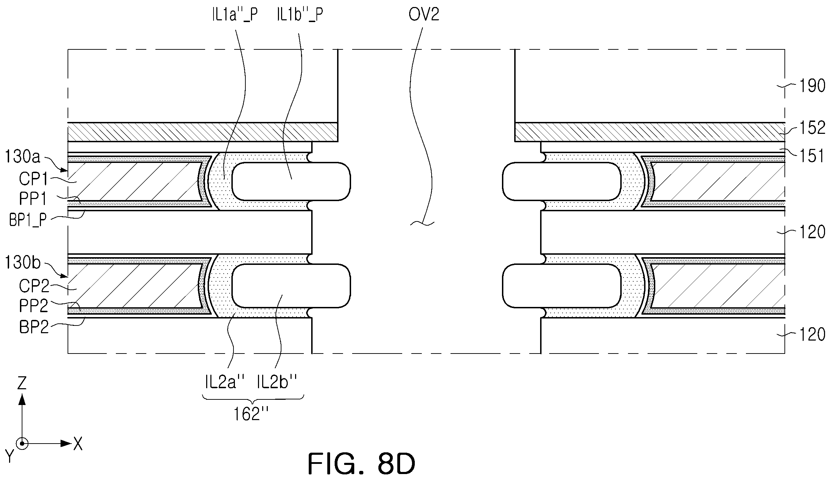

Referring to FIG. 8D, the first insulating liner 25 and the second insulating liner 23 surrounding the second vertical through-hole OV2 may be removed. The second insulating liner 23 may have an etch rate lower than that of the first insulating liner 25. The first insulating liner 25 may be etched, such that the first insulating pattern IL1a"_P and IL2a" may remain in the first horizontal tunnel layer OH1', the second insulating liner 23 may be etched such that the second insulating pattern IL1b"_P and IL2b" including a portion formed between the first insulating pattern IL1a"_P and IL2a" and protruding from the end of the first insulating pattern IL1a"_P and IL2a" toward the second vertical through-hole OV2. In various example embodiments, the upper surface of the first insulating pattern IL1a"_P and IL2a" may be disposed on the same level as the upper surface of the first and second gate electrode portions 130a and 130b. The lower surface of the first insulating pattern IL1a"_P and IL2a" may be disposed on the same level as the lower surface of the first and second gate electrode portions 130a and 130b.

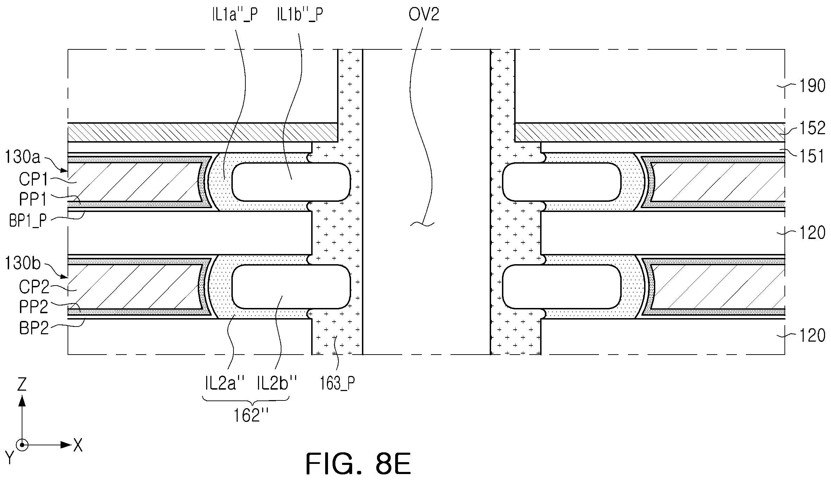

Referring to FIG. 8E, the sealing pattern 163_P may be deposited on the side surface of the second vertical through-hole OV2. The sealing pattern 163_P may fill a space in a step difference between the first insulating pattern IL1a"_P and the second insulating pattern IL1b"_P exposed to the side surface of the second vertical through-hole OV2 and unevenness of the second contact insulating layer 162" due to a difference in etch speeds in the process of removing the first insulating liner 25 and the second insulating liner 23 surrounding the second vertical through-hole OV2.

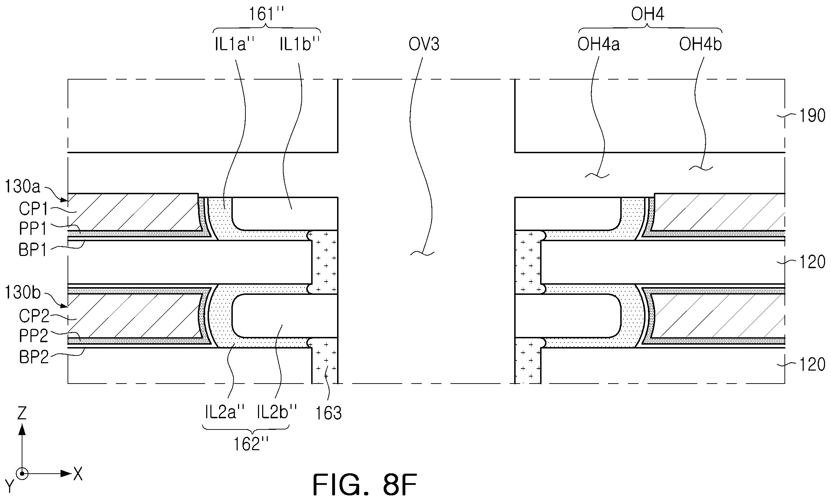

Referring to FIG. 8F, the fourth horizontal tunnel layer OH4 may be formed by removing the first and second sacrificial pad layers 151 and 152. By performing a trimming process on the sealing pattern 163_P, the sealing pattern 163 exposing the side surfaces of the second insulating patterns IL1b" and IL2b" may be formed.

The first and second sacrificial pad layers 151 and 152 may be removed by an etching process. The etching process may include a wet etching and/or dry etching process. In the process of removing the first and second sacrificial pad layers 151 and 152, the upper surface of first insulating pattern IL1a"_P in contact with first sacrificial pad layer 151 may be partially etched and the first insulating pattern IL1a" may be formed. In various example embodiments, the upper surface of the second insulating pattern IL1b"_P may be partially etched, such that the upper surface of the second insulating pattern IL1b" may be exposed by the fourth horizontal tunnel layer OH4.

The sealing pattern 163_P disposed on the side surface of the first and second sacrificial pad layers 151, 152 and the second vertical through-hole OV2 in contact with the cell region insulating layer 190 through the trimming process for the sealing pattern 163_P is removed. A portion of the sealing pattern 163_P disposed on the lower surface of the second insulating pattern IL1b" and IL2b" protruding toward the third vertical through-hole OV3 may be etched in the horizontal direction such that the side surface of the second insulating pattern IL1b" and IL2b" may be exposed. The side surface of the second insulating pattern IL1b" and IL2b" and the external side surface of sealing pattern 163 exposed toward the third vertical through-hole OV3 may form one flat surface in the third direction (Z-direction).

The first blocking layer BP1_P exposed through the fourth horizontal tunnel layer OH4 may be removed such that the first blocking layer BP1 covering one side surface and a bottom surface of the first gate electrode portion 130a may be formed. The upper surface of "first insulating pattern IL1a" may be exposed through a 4-1 horizontal tunnel layer OH4a. In various example embodiments, by removing the first blocking layer BP1_P exposed through the fourth horizontal tunnel layer OH4, the upper surface of the first gate electrode portion 130a may be exposed.

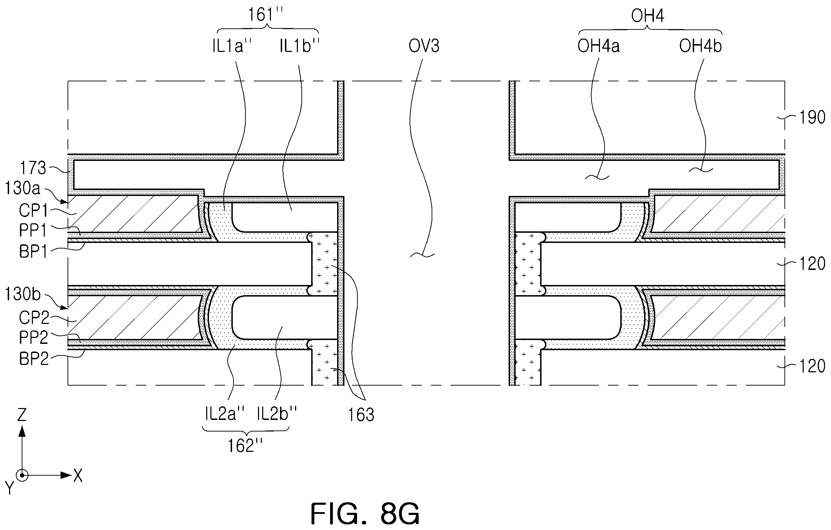

Referring to FIG. 8G, a conductive liner 173 may be deposited according to the surface profile of the third vertical through-hole OV3 and the fourth horizontal tunnel layer OH4. The conductive liner 173 may cover the upper surface of the first gate electrode portion 130a and the upper surface of the first contact insulating layer 161" exposed through the fourth horizontal tunnel layer OH4. The conductive liner 173 may extend from the upper surface of the first gate electrode portion 130a and the upper surface of the first contact insulating layer 161" along the side surface of the second insulating patterns IL1b" and IL2b" and the side surface of the sealing pattern 163.

Thereafter, referring to FIG. 4C, the contact plug 170 may be formed by depositing a conductive material in the third vertical through-hole OV3 and the fourth horizontal tunnel layer OH4.

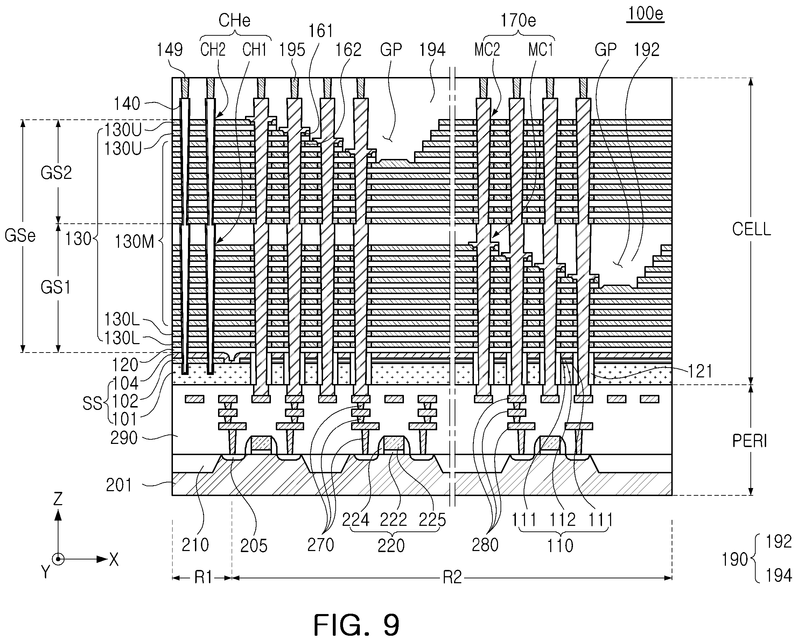

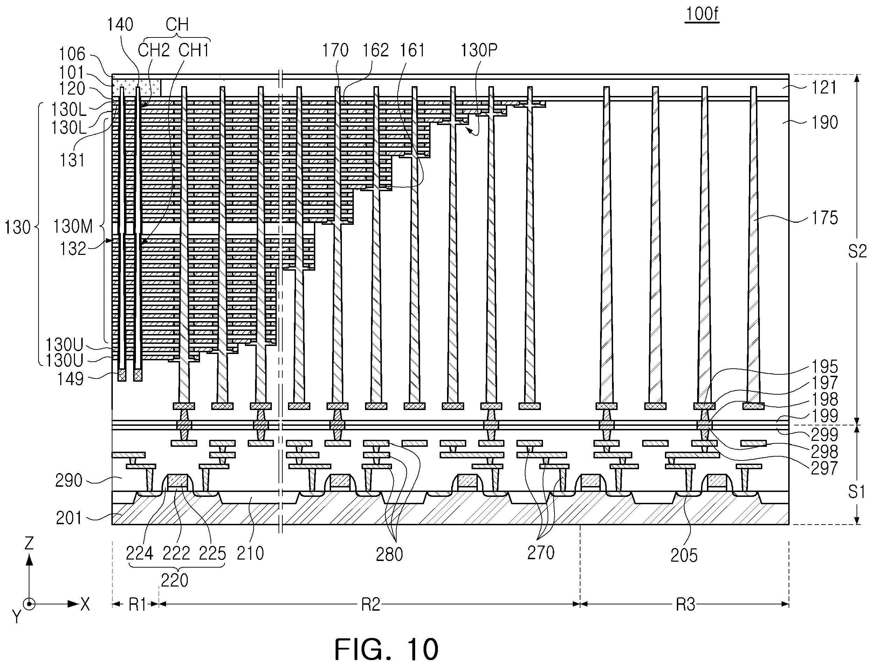

FIGS. 9 and 10 are cross-sectional diagrams illustrating a semiconductor device according to other various example embodiments.

Referring to FIG. 9, in a semiconductor device 100e, the shapes of the gate structure GSe, the channel structures CHe, and the contact plugs 170e may be different from the example embodiments in FIG. 1B.

The gate structure GSe may include first and second stack structures GS1 and GS2 vertically stacked. Each of the channel structures CHe may include first and second channel portions CH1 and CH2 penetrating the first and second stack structures GS1 and GS2, respectively. Each of the contact plugs 170e may include first and second contact portions MC1 and MC2 stacked in the third direction (Z-direction). The first and second contact portions MC1 and MC2 may penetrate the first and second stack structures GS1 and GS2 of the gate structure GS, respectively. In various example embodiments, an interfacial surface between the first contact portion MC1 and the second contact portion MC2 may be disposed on the same level as an interfacial surface between the first and second channel portions CH1 and CH2.

As described above, in various example embodiments, the number of stack structures included in the gate structure GS may be varied, and accordingly, the number of the stacked portions in the third direction (Z-direction) in each of the channel structures CHe and the contact plugs 170e may be varied.

Referring to FIG. 10, semiconductor device 100f may include a first semiconductor structure S1 and a second semiconductor structure S2 bonded to each other using a wafer bonding method.

The description of the peripheral circuit region PERI described above with reference to FIG. 1B may be applied to the first semiconductor structure S1. However, the first semiconductor structure S1 may further include bonding structures such as first bonding vias 297, first bonding metal layers 298, and first bonding insulating layer 299. The first bonding vias 297 may be disposed on an upper portion of the circuit interconnection lines 280 in an uppermost portion and may be connected to the circuit interconnection lines 280. At least a portion of the first bonding metal layers 298 may be connected to the first bonding vias 297 on the first bonding vias 297. The first bonding metal layers 298 may be connected to second bonding metal layers 198 of the second semiconductor structure S2. The first bonding metal layers 298, together with the second bonding metal layers 198, may provide an electrical connection path according to bonding between the first semiconductor structure S1 and the second semiconductor structure S2. A portion of the first bonding metal layers 298 may not be connected to the circuit interconnection lines 280 in the lower portion and may be disposed only for bonding. The first bonding vias 297 and the first bonding metal layers 298 may include a conductive material, for example, copper (Cu). The first bonding insulating layer 299 may be disposed around the first bonding metal layers 298. The first bonding insulating layer 299 may also function as a diffusion barrier of the first bonding metal layers 298 and may include, for example, at least one of SiN, SiON, SiCN, SiOC, SiOCN, and SiO. However, example embodiments are not limited thereto.

Unless otherwise indicated, the description of the memory cell region CELL described above with reference to FIGS. 1A to 1C may be applied to the second semiconductor structure S2. The second semiconductor structure S2 may further include second bonding vias 197, second bonding metal layers 198, and second bonding insulating layer 199, which are bonding structures. The second semiconductor structure S2 may further include a passivation layer 106 covering an upper surface of the second substrate 101.

The second bonding vias 197 and the second bonding metal layers 198 may be disposed below the cell interconnection lines 195 in a lowermost portion. The second bonding vias 197 may connect the cell interconnection lines 195 to the second bonding metal layers 198, and the second bonding metal layers 198 may be bonded to the first bonding metal layers 298 of the first semiconductor structure S1. The second bonding insulating layer 199 may be bonded and connected to the first bonding insulating layer 299 of the first semiconductor structure S1. The second bonding vias 197 and the second bonding metal layers 198 may include a conductive material, for example, copper (Cu). The second bonding insulating layer 199 may include, for example, at least one of SiO, SiN, SiCN, SiOC, SiON, and SiOCN. However, example embodiments are not limited thereto.

The first and second semiconductor structures S1 and S2 may be bonded to each other by bonding between the first bonding metal layers 298 and the second bonding metal layers 198 and bonding between the first bonding insulating layer 299 and the second bonding insulating layer 199. The bonding between the first bonding metal layers 298 and the second bonding metal layers 198 may be, for example, copper (Cu)-copper (Cu) bonding, and the bonding between the first bonding insulating layer 299 and the second bonding insulating layer 199 may be, for example, dielectric-dielectric bonding such as SiCN-SiCN bonding. The first and second semiconductor structures S1 and S2 may be bonded to each other by hybrid bonding including copper (Cu)-copper (Cu) bonding and dielectric-dielectric bonding. However, example embodiments are not limited thereto.

The passivation layer 106 may be disposed on the upper surface of the second substrate 101 and may protect the semiconductor device 100f. The passivation layer 106 may include at least one insulating material, for example, at least one of silicon oxide, silicon nitride, and silicon carbide. However, example embodiments are not limited thereto. The substrate insulating layer 121 may be disposed relatively widely in the second region R2 to cover an upper end of the contact plugs 170. However, in various example embodiments, the arrangement of the substrate insulating layer 121 may be varied in the range in which the contact plugs 170 from the substrate insulating layer 121 are electrically isolated from each other.

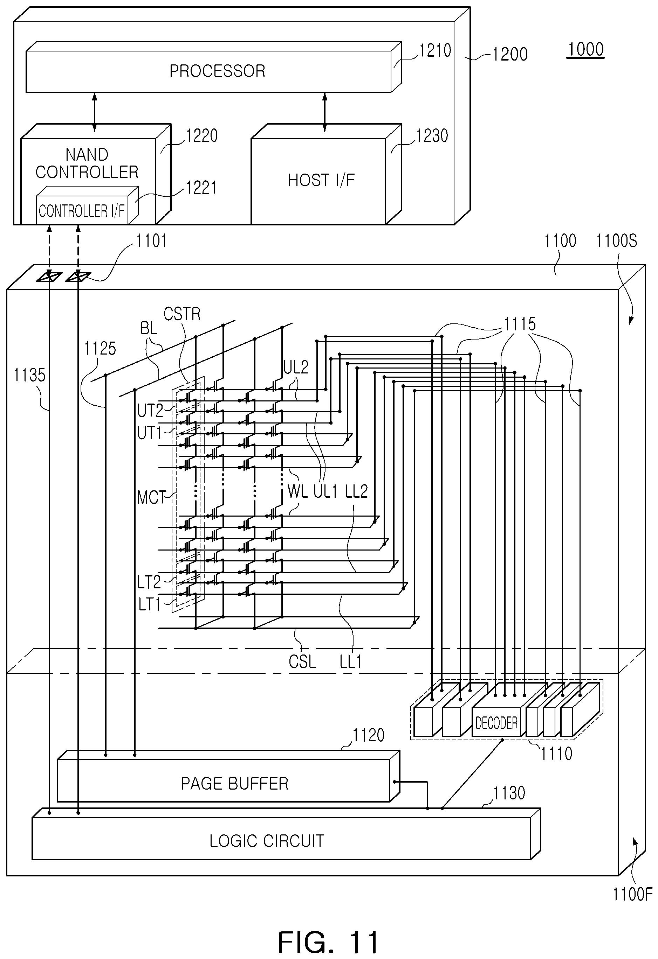

FIG. 11 is a diagram illustrating a data storage system including a semiconductor device according to various example embodiments.

Referring to FIG. 11, a data storage system 1000 may include a semiconductor device 1100 and a controller 1200 electrically connected to the semiconductor device 1100. The data storage system 1000 may be implemented as a storage device including one or a plurality of semiconductor devices 1100 or an electronic device including a storage device. For example, the data storage system 1000 may be implemented as a solid state drive device (SSD) including one or a plurality of semiconductor devices 1100, a universal serial bus (USB), a computing system, a medical device, or a communication device.

The semiconductor device 1100 may be implemented as a non-volatile memory device, such as, for example, the NAND flash memory device described in the aforementioned example embodiments with reference to FIGS. 1A to 1C. The semiconductor device 1100 may include a first structure 1100F and a second structure 1100S on the first structure 1100F. In various example embodiments, the first structure 1100F may be disposed on the side of the second structure 1100S. The first structure 1100F may be implemented as a peripheral circuit structure including a decoder circuit 1110, a page buffer 1120, and a logic circuit 1130. The second structure 1100S may be implemented as a memory cell structure including a bitline BL, a common source line CSL, wordlines WL, first and second gate upper lines UL1 and UL2, first and second gate lower lines LL1 and LL2 and memory cell strings CSTR disposed between the bitline BL and the common source line CSL.

In the second structure 1100S, each of the memory cell strings CSTR may include lower transistors LT1 and LT2 adjacent to the common source line CSL, upper transistors UT1 and UT2 adjacent to the bitline BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be varied in various example embodiments.

In various example embodiments, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The wordlines WL may be configured as gate electrodes of the memory cell transistors MCT, and the gate upper lines UL1 and UL2 may be configured as gate electrodes of the upper transistors UT1 and UT2, respectively.

In various example embodiments, the lower transistors LT1 and LT2 may include a lower erase control transistor LT1 and a ground select transistor LT2 connected to each other in series. The upper transistors UT1 and UT2 may include a string select transistor UT1 and an upper erase control transistor UT2 connected to each other in series. At least one of the lower erase control transistor LT1 and the upper erase control transistor UT2 may be used in an erase operation for erasing data stored in the memory cell transistors MCT using a GIDL phenomenon.

The common source line CSL, the first and second gate lower lines LL1 and LL2, the wordlines WL, and the first and second gate upper lines UL1 and UL2 may be electrically connected to the decoder circuit 1110 through first connection interconnections 1115 extending from the first structure 1100F to the second structure 1100S. The bitlines BL may be electrically connected to the page buffer 1120 through second connection interconnections 1125 extending from the first structure 1100F to the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through the input/output pads 1101 electrically connected to the logic circuit 1130. The input/output pads 1101 may be electrically connected to the logic circuit 1130 through an input/output connection line 1135 extending from the first structure 1100F to the second structure 1100S.

The controller 1200 may include a processor 1210, a NAND controller 1220, and a host interface 1230. In various example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a desired (and/or alternatively predetermined) firmware, and may access the semiconductor device 1100 by controlling the NAND controller 1220. The NAND controller 1220 may include a controller interface 1221 processing communication with the semiconductor device 1100. Through the controller interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When a control command from an external host is received through the host interface 1230, the processor 1210 may control the semiconductor device 1100 in response to the control command.

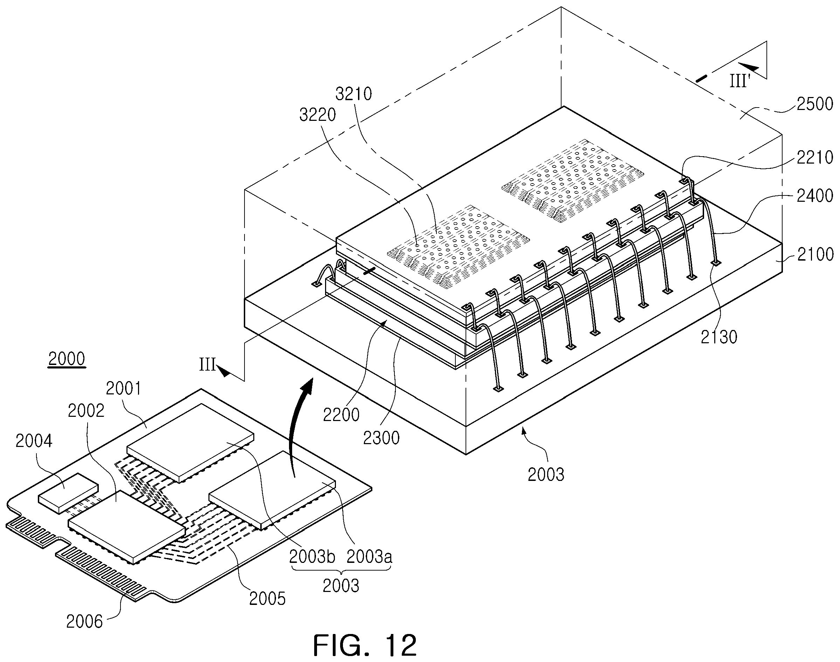

FIG. 12 is a perspective diagram illustrating a data storage system including a semiconductor device according to various example embodiments.

Referring to FIG. 12 a data storage system 2000 in various example embodiments may include a main board 2001, a controller 2002 mounted on the main board 2001, one or more semiconductor packages 2003, and a DRAM 2004. The semiconductor package 2003 and the DRAM 2004 may be connected to the controller 2002 by interconnection patterns 2005 formed on the main board 2001.

The main board 2001 may include a connector 2006 including a plurality of pins coupled to an external host. The number and arrangement of the plurality of pins in the connector 2006 may be varied depending on a communication interface between the data storage system 2000 and the external host. In various example embodiments, the data storage system 2000 may communicate with an external host according to one of interfaces from among universal serial bus (USB), peripheral component interconnect express (PCI-Express), serial advanced technology attachment (SATA), M-Phy for universal flash storage (UFS). In various example embodiments, the data storage system 2000 may operate by power supplied from an external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000.

The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. When the data storage system 2000 may include the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of the semiconductor chips 2200, respectively, a connection structure 2400 electrically connecting the semiconductor chips 2200 to the package substrate 2100, and a molding layer 2500 covering the semiconductor chips 2200 and the connection structure 2400 on the package substrate 2100.

The package substrate 2100 may be configured as a printed circuit board including package upper pads 2130. Each semiconductor chip 2200 may include an input/output pad 2210. The input/output pad 2210 may correspond to the input/output pad 1101 in FIG. 11. Each of the semiconductor chips 2200 may include gate stack structures 3210 and channel structures 3220. Each of the semiconductor chips 2200 may include the semiconductor device described in the aforementioned example embodiments with reference to FIGS. 1A to 1C.

In various example embodiments, the connection structure 2400 may be configured as a bonding wire electrically connecting the input/output pad 2210 to the package upper pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In various example embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In the various example embodiments, the controller 2002 and the semiconductor chips 2200 may be included in a single package. In various example embodiments, the controller 2002 and the semiconductor chips 2200 may be mounted on an interposer substrate different from the main board 2001, and the controller 2002 and the semiconductor chips 2200 may be connected to each other by interconnection formed on the interposer substrate.

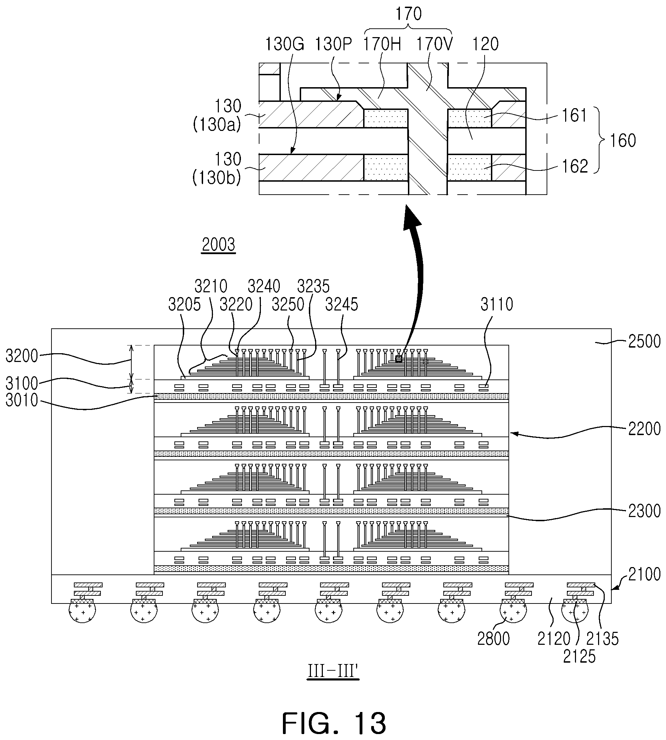

FIG. 13 is a cross-sectional diagram illustrating a semiconductor package according to various example embodiments.

FIG. 13 illustrates various example embodiments of the semiconductor package 2003 in FIG. 12, a region of the semiconductor package 2003 taken along line III-III'.

Referring to FIG. 13, in the semiconductor package 2003, the package substrate 2100 may be implemented as a printed circuit substrate. The package substrate 2100 may include a package substrate body 2120, package upper pads 2130 (in FIG. 12) disposed on an upper surface of the package substrate body 2120, lower pads 2125 disposed on the lower surface of the package substrate body 2120 or exposed through the lower surface, and internal interconnections 2135 electrically connecting the package upper pads 2130 to the lower pads 2125 in the package substrate body 2120. The lower pads 2125 may be connected to the interconnection patterns 2005 of the main board 2001 of the data storage system 2000 through the conductive connection portions 2800 as illustrated in FIG. 12.

Each of the semiconductor chips 2200 may include a semiconductor substrate 3010 and a first structure 3100 and a second structure 3200 stacked in order on the semiconductor substrate 3010. The first structure 3100 may include a peripheral circuit region including peripheral interconnections 3110. The second structure 3200 may include a common source line 3205, a gate stack structure 3210 on the common source line 3205, channel structures 3220 penetrating through the gate stack structure 3210, bit lines 3240 electrically connected to the channel structures 3220, and contact plugs (the contact plugs 170 in FIG. 1B) electrically connected to the word lines (the gate electrodes 130 in FIG. 1A) of the gate stack structure 3210. The first structure 3100 may further include contact insulating layers 160 as illustrated in the enlarged diagram. The contact insulating layers 160 may include a first contact insulating layer 161 disposed between the gate contact region 130P and the vertical extension portion 170V of contact plug 170, and a second contact insulating layer 162 disposed between the gate stack region 130G of the lower portion of gate contact region 130P and the vertical extension portion 170V. The contact plugs 170 may include a vertical extension portion 170V penetrating the gate electrodes 130 and the interlayer insulating layers 120, and a horizontal extension portion 170H extending from the vertical extension portion 170V and in contact with the first contact insulating layer 161 and the gate contact region 130P.

Each of the semiconductor chips 2200 may include a through-interconnection 3245 electrically connected to the peripheral interconnections 3110 of the first structure 3100 and extending into the second structure 3200. The through-interconnection 3245 may be disposed on an external side of the gate stack structure 3210 and may further be disposed to penetrate through the gate stack structure 3210. Each of the semiconductor chips 2200 may further include an input/output pad 2210 (in FIG. 2) electrically connected to the peripheral interconnections 3110 of the first structure 3100.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

According to the aforementioned example embodiments, the semiconductor device and the data storage system including the same may include gate electrodes having a gate contact region, and a contact plug connected to the gate contact region, and the gate contact region may be connected to the contact plug through the horizontal extension portion disposed on the upper surface of the gate contact region. Accordingly, deformation of the gate stack region disposed in the lower portion of the gate contact region and the contact insulating layers disposed between the gate stack region and vertical extension portion depending on the contact position of the gate contact region and the contact plug and reduction of reliability therefrom may be reduced or prevented. a semiconductor device having improved reliability and a data storage system including the same may be provided.

While various example embodiments have been illustrated and described above, it will be configured as apparent to those skilled in the art that modifications and variations could be made without departing from the scope of the present disclosure as defined by the appended claims.

Embodiments are set out in the following clauses:
Clause 1 A semiconductor device, comprising:
   a stack pattern having a memory cell array region and a staircase region;
   a stack structure extending from the memory cell array region to the staircase region on the stack pattern,
   wherein the stack structure includes
      interlayer insulating layers and gate electrodes stacked alternately in a vertical direction, and
      the gate electrodes include gate contact pads arranged in a staircase form on the staircase region;
   a channel structure penetrating the stack structure in the memory cell array region and extending in the vertical direction;
   contact plugs penetrating the gate electrodes and the interlayer insulating layers in the staircase region; and
   contact insulating layers stacked alternately with the interlayer insulating layers and surrounding the contact plugs,
   wherein the contact insulating layers include
      first contact insulating layers between the gate contact pads and the contact plugs, and
      second contact insulating layers stacked alternately with the interlayer insulating layers in a lower portion of the gate contact pads, and
      the second contact insulating layers surrounding the contact plugs, wherein each of the contact plugs includes
      a vertical extension portion extending in the vertical direction,
      a horizontal extension portion extending from the vertical extension portion in a horizontal direction, and
      the horizontal extension portion being in contact with each of the first contact insulating layers and the gate contact pads, and
   wherein a height of each of the first contact insulating layers is smaller than a height of each of the second contact insulating layers.
Clause 2 The semiconductor device of clause 1,
   wherein each of the interlayer insulating layers include
      a first interlayer insulating layer in a lower portion of the first contact insulating layers, and
      a second interlayer insulating layer in a lower portion of the second contact insulating layer,
   wherein each of the first contact insulating layers includes
      a first flat portion and a first protrusion extending from the first flat portion, and
      the first protrusion protruding toward the first interlayer insulating layer, and wherein each of the second contact insulating layers includes
      a second flat portion and a second protrusion extending from the second flat portion, and
      the second protrusion protruding toward the first interlayer insulating layer and the second interlayer insulating layer.
Clause 3 The semiconductor device of clause 1 or clause 2,
   wherein each of the interlayer insulating layers includes
      a first insulating pattern and a second insulating pattern including
         a first portion surrounded by the first insulating pattern,
         a second portion extending from the first portion, and
         the second portion protruding toward the vertical extension portion,
   wherein the first insulating pattern includes the first insulating material, and
   wherein the second insulating pattern includes a second insulating material different from the first insulating material.
Clause 4 The semiconductor device of clause 3, further comprising:
   a sealing pattern extending to a region between the interlayer insulating layers and the vertical extension portion from the second portion of the second insulating pattern; and
   wherein each of the contact plugs further includes
      a conductive liner covering an upper surface of the gate contact pads,
      an upper surface of the first contact insulating layers, and
      an external side surface of the sealing pattern.
Clause 5 A data storage system, comprising:
   a semiconductor storage device including
      a first semiconductor structure including circuit devices and circuit interconnections electrically connected to the circuit devices,
      a second semiconductor structure on one surface of the first semiconductor structure and including a first region and a second region, and
      an input/output pad electrically connected to the circuit devices; and
   a controller electrically connected to the semiconductor storage device through the input/output pad and controlling the semiconductor storage device,
   wherein the second semiconductor structure includes:
      a plate layer;
      gate electrodes stacked and spaced apart from each other in a vertical direction on an upper surface of the plate layer,
      the gate electrodes extending by different lengths on the second region in a first direction intersecting the vertical direction, and respectively including a gate contact region;
      interlayer insulating layers stacked alternately with the gate electrodes;
      a channel structure penetrating the gate electrodes and the interlayer insulating layers in the first region and extending in the vertical direction;
      contact plugs penetrating the gate contact region of each of the gate electrodes in the second region, extending in the vertical direction, and electrically connecting the gate electrodes to a portion of the circuit interconnections, respectively;
      first contact insulating layers stacked alternately with the interlayer insulating layers between the gate contact region and the contact plugs;
      the first contact insulating layers surrounding the contact plugs;
      second contact insulating layers stacked alternately with the interlayer insulating layers in a lower portion of the gate contact region; and
      second contact insulating layers surrounding the contact plugs,
   wherein each of the contact plugs includes
      a vertical extension portion extending in the vertical direction,
      a horizontal extension portion extending from the vertical extension portion in a horizontal direction,
      the horizontal extension portion overlapping each of the first contact insulating layers and the gate contact region,
      a conductive liner extending to a region between the horizontal extension portion and the first contact insulating layers, and
      the conductive liner further extending to a region between the horizontal extension portion and the gate contact region.
Clause 6 The data storage system of clause 5, wherein the conductive liner extends to a region between the first and second contact insulating layers and the vertical extension portion, and
   the conductive liner further extending to a region between the interlayer insulating layers and the vertical extension portion.

## Claims

1. A semiconductor device, comprising:
a first semiconductor structure including a substrate, circuit devices on the substrate, and circuit interconnections on the circuit devices; and
a second semiconductor structure on the first semiconductor structure and having first and second regions;
wherein the second semiconductor structure includes:
a plate layer;
gate electrodes
stacked and spaced apart from each other on an upper surface of the plate layer in a vertical direction,
extending by different lengths on the second region in a first direction intersecting the vertical direction, and
including a gate contact region;
interlayer insulating layers stacked alternately with the gate electrodes;
a channel structure penetrating the gate electrodes and the interlayer insulating layers in the first region and extending in the vertical direction;
contact plugs
penetrating the gate electrodes in the second region,
extending in the vertical direction, and
electrically connecting the gate electrodes to a portion of the circuit interconnections, respectively; and
contact insulating layers
stacked alternately with the interlayer insulating layers,
surrounding the contact plugs, and
including first contact insulating layers between the gate contact region and the contact plugs,
wherein each of the contact plugs includes
a vertical extension portion extending in the vertical direction,
a horizontal extension portion extending from the vertical extension portion in a horizontal direction and overlapping the gate contact region and the first contact insulating layer in the vertical direction, and
a conductive liner extending to a region between the horizontal extension portion and the first contact insulating layers and to a region between the horizontal extension portion and the gate contact region.

2. The semiconductor device of claim 1,
wherein the contact plugs include a first conductive material being the same as a material of the gate electrodes, and
the conductive liner includes a second conductive material being different from the first conductive material.

3. The semiconductor device of claim 1 or claim 2, wherein an upper surface of the gate contact region is on a level higher than a level of an upper surface of each of the first contact insulating layers.

4. The semiconductor device of any preceding claim, wherein a height of a first portion of the horizontal extension portion overlapping the gate contact region is smaller than a height of a second portion of the horizontal extension portion overlapping the first contact insulating layers.

5. The semiconductor device of any preceding claim,
wherein the contact insulating layers further include second contact insulating layers surrounding the contact plugs in a lower portion of the gate contact region, and
a height of each of the second contact insulating layers is greater than a height of each of the first contact insulating layers.

6. The semiconductor device of claim 5,
wherein the gate electrodes further include a gate stack region in contact with the second contact insulating layer, and
a height of the gate stack region is greater than a height of the gate contact region.

7. The semiconductor device of any preceding claim, further comprising:
a sealing pattern extending from the contact insulating layers and between the interlayer insulating layer and the vertical extension portion,
wherein the sealing pattern includes silicon nitride.

8. The semiconductor device of claim 7, wherein the conductive liner extends to a region between the contact insulating layers and the vertical extension portion and to a region between the sealing pattern and the vertical extension portion.

9. The semiconductor device of any preceding claim,
wherein each of the contact insulating layers include
a first insulating pattern and a second insulating pattern having a portion surrounded by the first insulating pattern,
wherein the first insulating pattern includes silicon oxide, and
the second insulating pattern includes silicon nitride.

10. The semiconductor device of claim 9, wherein a first thickness of the first insulating pattern of the first contact insulating layers on an upper surface of the second insulating pattern of the first contact insulating layers is smaller than a second thickness of the first insulating pattern of the first contact insulating layers on a lower surface of the second insulating pattern of the first contact insulating layers.

11. The semiconductor device of claim 9 or claim 10, wherein the second insulating pattern includes a first void and a second void, the second void being spaced apart from the first void in the first direction.

12. The semiconductor device of claim 11, wherein a length of the first void in the first direction is greater than a length of the second void in the first direction.

13. The semiconductor device of claim 11 or claim 12, wherein each of the first insulating pattern and the second insulating pattern includes
a flat portion extending in the horizontal direction,
a protrusion extending from the flat portion,
the protrusion extending between the flat portion and the vertical extension portion, and
the protrusion further protruding toward the interlayer insulating layers.

14. The semiconductor device of claim 13, wherein the protrusion is between the first void and the second void.

15. The semiconductor device of claim 1, wherein the contact insulating layers further include second contact insulating layers surrounding the contact plugs in a lower portion of the gate contact region, and
wherein each of the interlayer insulating layers include
a first interlayer insulating layer in a lower portion of the first contact insulating layers, and
a second interlayer insulating layer in a lower portion of the second contact insulating layer,
wherein each of the first contact insulating layers includes
a first flat portion and a first protrusion extending from the first flat portion, and
the first protrusion protruding toward the first interlayer insulating layer, and wherein each of the second contact insulating layers includes
a second flat portion and a second protrusion extending from the second flat portion, and
the second protrusion protruding toward the first interlayer insulating layer and the second interlayer insulating layer.
